# EUROPEAN PATENT SPECIFICATION

(11) **EP 3 648 173 B1**
(45) Date of publication and mention of the grant of the patent: **24.05.2023**
(21) Application number: 18203433.0
(22) Date of filing: 30.10.2018
(51) Int. Cl.: H01L 31/02, H01L 31/0443, H01L 31/0465, H01L 31/0392

(54) **THIN-FILM PHOTOVOLTAIC MODULE WITH INTEGRATED ELECTRONICS AND METHODS FOR MANUFACTURING THEREOF**
DÜNNSCHICHTFOTOVOLTAIKMODUL MIT INTEGRIERTER ELEKTRONIK UND VERFAHREN ZUR HERSTELLUNG DAVON
MODULE PHOTOVOLTAÏQUE À FILM MINCE COMPRENANT DES COMPOSANTS ÉLECTRONIQUES INTÉGRÉS ET PROCÉDÉS DE FABRICATION DE CELUI-CI

(43) Date of publication of application: 06.05.2020
(73) Proprietor: IMEC vzw, 3001 Leuven (BE); Universiteit Hasselt, 3500 Hasselt (BE)
(72) Inventor: Meuris, Mr. Marc, 3001 Leuven (BE)
(74) Representative: DenK iP bv

(56) References cited:
- EP-A1- 2 249 394
- EP-A1- 3 358 630
- EP-A2- 2 498 297
- KR-A- 20120 114 002
- US-A1- 2012 291 835
- US-A1- 2014 230 885

## Description

### Field

The present disclosure relates to thin-film photovoltaic modules comprising at least one integrated electronic device, such as for example a bypass diode or an electronic switch.

The present disclosure further relates to methods for manufacturing such thin-film photovoltaic modules with integrated electronic devices.

### State of the art

Thin-film photovoltaic modules with integrated bypass diodes and methods for integrating bypass diodes in thin-film photovoltaic modules are known. Thin-film photovoltaic modules typically comprise a plurality of thin photovoltaic cells monolithically integrated on a substrate and electrically connected in series. Bypass diodes may be added to protect the photovoltaic cells from reverse bias breakdown, which may for example occur in case of partial module shading. When one or more cells are shaded, part of the current that is generated by the cells connected in series with the shaded cells is drained to the connected bypass diode, thereby reducing the reverse voltage over the shaded cell(s). As a result, the current through the shaded cell(s) is limited and the risk of permanent damage to these cells is avoided or substantially reduced.

WO 2010/077952 A1 discloses a thin-film photovoltaic module comprising at least one integrated bypass diode electrically connecting conductive back surfaces of at least two thin-film photovoltaic cells. The bypass diode and the photovoltaic cells are encapsulated and packed with a protective shell such that at least one bypass diode is placed between at least one photovoltaic cell and a bottom protective sheet. The solution described in WO 2010/077952 A1 can only be used in embodiments wherein the thin-film photovoltaic cells are fabricated on a conductive substrate, wherein the photovoltaic cells are first separately manufactured and then interconnected by stringing or shingling. This solution is not applicable to thin-film photovoltaic modules wherein the thin-film photovoltaic cells are monolithically integrated on a substrate.

For thin-film photovoltaic cells monolithically integrated on an electrically non-conductive substrate such as for example a glass substrate, the rear side contacts are not accessible after cell fabrication. Positioning the bypass diodes at the front side of the thin-film photovoltaic module and electrically connecting them to the front side contacts of the cells may be considered in such case. However, such approach causes additional shading losses, which is undesirable.

As an alternative, positioning the bypass diodes at an edge of the photovoltaic module and electrically connecting them to the front side contacts at the module edge may be considered in such case. The series connected thin-film photovoltaic cells typically have a cell length in the range between 3 mm and 9 mm and a cell width in the range between 50 cm and 160 cm. A plurality of cells, e.g. 60 to 100 cells, are connected in series (in their length direction) to form a thin-film photovoltaic module having a module length for example in the range between 30 cm and 90 cm and a module width in the range between 50 cm and 160 cm. The front side electrodes of thin-film photovoltaic cells are typically formed of an optically transparent conductive oxide having an electrical resistivity in the range between 0.2 and 1 mOhm cm, which typically results in a sheet resistance of 5 to 50 Ohm per square. Because of this relatively high electrical resistance, placing a bypass diode at a lateral edge of such a photovoltaic module may insufficiently protect shaded areas located near an opposite lateral edge of the module (i.e. at a relatively large distance from the bypass diode), because the electrical current to be drained to the bypass diode needs to be led through the (e.g. up to 160 cm long) front side electrodes. This may result in a current path between the shaded regions and the bypass diode having an electrical resistance that is larger than the electrical resistance of a current path through the shaded cells, and the bypass diode may thus be ineffective.

Photovoltaic modules with a reconfigurable arrangement of photovoltaic cells have been proposed. In such reconfigurable photovoltaic modules, the electrical connections between cells or groups of cells can be adapted, such that the cells or groups of cells can be electrically connected in series or in parallel, and/or a hybrid series/parallel connection between the cells or groups of cells can be established. This may allow for example adapting the electrical connections between cells or groups of cells during operation of the photovoltaic system, for example in response to partial module shading or non-uniform module illumination. It is an advantage that this may result in a higher performance (higher energy yield) of the module or system. Reconfigurability may be obtained by connecting electronic switches between cells or groups of cells. Other electronic devices, such as for example DC/DC converters may also be integrated into the module and connected between cells or groups of cells. However, integration of such electronic devices at an edge of a thin-film photovoltaic module may encounter high-resistance issues - similar to the high-resistance problems in case of integration of bypass diodes as described above -, resulting in ineffective or improper operation and high resistive losses.

Hence, there is a need for thin-film photovoltaic modules with integrated electronic devices, more in particular thin-film photovoltaic modules having a plurality of thin-film photovoltaic cells monolithically integrated on an electrically non-conductive substrate, wherein shading losses resulting from the integrated electronic devices are limited and wherein the electrical resistance of a current path between the plurality of thin-film photovoltaic cells and the integrated electronic devices is sufficiently low to enable proper, efficient operation of the electronic devices Document US 2012291835 A1 discloses thin-film solar cells with a diode positioned on the substrate at a lateral edge next to the solar cells and connected to the cells with conductive wires.

### Summary

It is an object of the present disclosure to provide thin-film photovoltaic modules comprising a plurality of monolithically integrated thin-film photovoltaic cells and comprising integrated electronic devices, such as for example integrated bypass diodes, switches or DC-DC converters, wherein shading losses resulting from the integrated electronic devices are limited and wherein the electrical resistance of a current path between the plurality of thin-film photovoltaic cells and the integrated electronic devices is sufficiently low to enable a desired, proper, efficient operation of the at least one electronic device.

It is a further object of the present disclosure to provide fabrication methods for such thin-film photovoltaic modules, wherein the fabrication methods are industrially applicable at a relatively low cost.

The above objectives are at least partially accomplished by a device and a method according to the present disclosure.

According to a first aspect the disclosure is related to a thin-film photovoltaic module comprising: a plurality of thin-film photovoltaic cells, each of the thin-film photovoltaic cells having a cell length and a cell width, wherein the plurality of thin film-photovoltaic cells is formed on an electrically insulating substrate with a rear side of the plurality of thin-film photovoltaic cells oriented towards the electrically insulating substrate, wherein each of the plurality of thin-film photovoltaic cells has an optically transparent front side electrode at a front side opposite to the rear side, wherein the plurality of thin-film photovoltaic cells is electrically connected in series in a direction corresponding to the cell length; and at least one electronic device comprising a first device electrode and a second device electrode, wherein the at least one electronic device comprises a bypass diode, a switch, a DC/DC converter, a capacitor, a transistor, an energy storage device or a load, wherein the at least one electronic device is positioned on the substrate at a lateral edge of the thin-film photovoltaic module, next to the plurality of thin-film photovoltaic cells, wherein the first device electrode is electrically connected to the front side electrode of a first thin-film photovoltaic cell by means of a first electrically conductive wire, and wherein the second device electrode is electrically connected to the front side electrode of a second thin-film photovoltaic cell by means of a second electrically conductive wire. The first electrically conductive wire overlays the front side electrode of the first thin-film photovoltaic cell and the second electrically conductive wire overlays the front side electrode of the second thin-film photovoltaic cell. The optically transparent front side electrode of the plurality of thin-film photovoltaic cells has an oblong shape, and the first electrically conductive wire is oriented substantially parallel with the oblong direction of the front side electrode of the first thin-film photovoltaic cell such that the first electrically conductive wire overlaps only with the front side electrode of the first thin-film photovoltaic cell and not with the front side electrode of another thin-film photovoltaic cell, and the second electrically conductive wire is oriented substantially parallel with the oblong direction of the front side electrode of the second thin-film photovoltaic cell such that the second electrically conductive wire overlaps only with the front side electrode of the second thin-film photovoltaic cell and not with the front side electrode of another thin-film photovoltaic cell. An electrical contact between the first electrically conductive wire and the front side electrode of the first thin-film photovoltaic cell and between the second electrically conductive wire and the front side electrode of the second thin-film photovoltaic cell is established over substantially the entire area where the electrically conductive wire overlays the corresponding front side electrode.

In embodiments, the thin-film photovoltaic module may comprise a plurality of electronic devices. The first device electrode may for example be an input electrode of the at least one electronic device and the second device electrode may for example be an output electrode of the at least one electronic device. The first device electrode may for example have a first polarity and the second device electrode may have a second polarity opposite to the first polarity.

In embodiments of the thin-film photovoltaic module of the present disclosure the at least one electronic device may be integrated in the module. In the context of the present disclosure, the at least one electronic device being integrated in the module means that it is part of the module. In embodiments of the thin-film photovoltaic module of the present disclosure the at least one electronic device may be encapsulated together with the plurality of thin-film photovoltaic cells, i.e. it may be embedded between a back encapsulation sheet, e.g. rear carrier or rear substrate, and a front encapsulation sheet, e.g. front carrier, front cover or superstrate, of the thin-film photovoltaic module. In embodiments of the thin-film photovoltaic module of the present disclosure the at least one electronic device may be located outside the module encapsulation. It may for example be provided in a junction box that may be part of the module, and typically placed at a rear side of the module.

It is an advantage of embodiments of the thin-film photovoltaic module of the present disclosure that an electrical resistance of a current path between the at least one electronic device and the plurality of photovoltaic cells may be substantially reduced. It is an advantage that this electrical resistance may be substantially reduced over the entire thin-film photovoltaic module width. It is an advantage of a substantially reduced electrical resistance that resistive losses may be substantially reduced or avoided, which may result in an improved, desired operation of the at least one electronic device and an improved reliability, an improved lifetime and/or an improved performance of the thin-film photovoltaic module.

For example, in embodiments of the thin-film photovoltaic module of the present disclosure wherein the at least one electronic device comprises at least one bypass diode, the electrical resistance of a current path between shaded regions of the thin-film photovoltaic module and the at least one bypass may be substantially reduced, such that is substantially lower than the electrical resistance of a current path through the shaded cells. It is an advantage that this may result in a substantially improved effectiveness of the bypass diode and thus a substantially improved protection against reverse voltage breakdown, leading to a substantial improvement of the lifetime of the thin-film photovoltaic module.

In a the thin-film photovoltaic module according to the first aspect of the present disclosure, the first electrically conductive wire preferably has an electrical resistance that is substantially lower than an electrical resistance of the front side electrode of the first thin-film photovoltaic cell and the second electrically conductive wire preferably has an electrical resistance that is substantially lower than an electrical resistance of the front side electrode of the second thin-film photovoltaic cell. This is advantageous in that it reduces the electrical resistance of a current path between the thin-film photovoltaic cells and the at least one electronic device, the more for areas of the thin-film photovoltaic cells located at a larger distance from the at least one electronic device, which may result in a substantial reduction of resistive losses. It is an advantage that this may lead to a more efficient operation of the at least one electronic device and an improved performance, such as an enhanced lifetime, an improved reliability or an enhanced energy output, of the thin-film photovoltaic module. For example, the first electrically conductive wire and the second electrically conductive wire may be metal wires (e.g. copper wires, aluminium wires, ...), the present disclosure not being limited thereto.

In a thin-film photovoltaic module according to the first aspect of the present disclosure, the plurality of thin-film photovoltaic cells may be monolithically integrated on the electrically insulating substrate.

In a thin-film photovoltaic module according to the first aspect of the present disclosure, the electrical connection may comprise a first electrical contact between the front side electrode of the first thin-film photovoltaic cell and the first electrically conductive wire and/or it may comprise a second electrical contact between the front side electrode of the second thin-film photovoltaic cell and the second electrically conductive wire. In such embodiments the first electrical contact preferably extends over a substantial part of the front side electrode of the first thin-film photovoltaic cell along the width direction of the cell and the second electrical contact preferably extends over a substantial part of the front side electrode of the second thin-film photovoltaic cell along the width direction of the cell.

In a thin-film photovoltaic module according the first aspect of the present disclosure the optically transparent front side electrode of the plurality of thin-film photovoltaic cells has an oblong shape, the first electrically conductive wire is oriented substantially parallel with the oblong direction of the front side electrode of the first thin-film photovoltaic cell and the second electrically conductive wire is oriented substantially parallel with the oblong direction of the front side electrode of the second thin-film photovoltaic cell. The substantially parallel orientation is such that the first electrically conductive wire overlaps only with the front side electrode of the first thin-film photovoltaic cell and not with the front side electrode of another thin-film photovoltaic cell, and such that the second electrically conductive wire overlaps only with the front side electrode of the second thin-film photovoltaic cell and not with the front side electrode of another thin-film photovoltaic cell. This is advantageous in that the risk of an undesired electrical short-cut between the front side electrodes of different thin-film photovoltaic cells may be substantially limited.

In a thin-film photovoltaic module according to the first aspect of the present disclosure, the plurality of thin-film photovoltaic cells may have a cell width that is substantially larger than their cell length. For example, the cell length of the plurality of thin-film photovoltaic cells may be in the range between 3 mm and 50 mm. For example, the cell width of the plurality of thin-film photovoltaic cells may be in the range between 60 cm and 160 cm.

The thin-film photovoltaic module according to the first aspect of the present disclosure may further comprise a plurality of electrically conductive elements above the optically transparent front side electrode of at least part of the plurality of thin-film photovoltaic cells, preferably on the front side electrode of each of the plurality of thin-film photovoltaic cells, wherein the plurality of electrically conductive elements is in electrical contact with the underlying front side electrode, wherein the front side electrode and the plurality of electrically conductive elements have an oblong shape and wherein the plurality of electrically conductive elements is oriented with their oblong direction at an angle of at least 60 degrees, more preferred at an angle larger than 70 degrees, more preferred at an angle larger than 80 degrees with respect to the oblong direction of the underlying front side electrode. For example, the plurality of electrically conductive elements may be oriented with their oblong direction substantially orthogonal to the oblong direction of the underlying front side electrode. The plurality of electrically conductive elements may be positioned at spaced locations, these spaced locations being spread over the underlying front side electrode along the width direction of the thin-film photovoltaic module, preferably being spread over substantially the entire width of the underlying front side electrode. This is advantageous in that it enables thin-film photovoltaic modules with an increased cell length, without substantially increasing the electrical series resistance of the cells and the module. It is an advantage of an increased cell length that, for a given thin-film photovoltaic module size, losses in active area due to the series interconnection of the cells may be reduced. It is an advantage that this may result in an increase of the active area for a given thin-film photovoltaic module size and thus in an increased energy generation per unit area.

In a thin-film photovoltaic module according to the first aspect of the present disclosure, the first electrically conductive wire and the second electrically conductive wire may have a diameter in the range between 20 micrometer and 200 micrometer. It is an advantage that this allows limiting shading losses caused by the presence of the electrically conductive wires at a front side of the thin-film photovoltaic cells, and simultaneously reducing an electrical resistance of a current path between the thin-film photovoltaic cells and the at least one electronic device.

In a thin-film photovoltaic module according to the first aspect of the present disclosure, the at least one electronic device may bridge a plurality of thin-film photovoltaic cells connected in series between the first thin-film photovoltaic cell and the second photovoltaic cell, the number of bridged thin-film photovoltaic cells being for example in the range between 5 and 20.

According to a second aspect the disclosure is related to a method for fabricating a thin-film photovoltaic module. In general, features of the second aspect of the present disclosure provide similar advantages as discussed above in relation to first aspect of the disclosure.

A method for fabricating a thin-film photovoltaic module is provided, the method comprising: first forming a plurality of series-connected thin-film photovoltaic cells on an electrically insulating substrate with a rear side of the plurality of thin-film photovoltaic cells oriented towards the substrate, wherein forming the plurality of series-connected thin-film photovoltaic cells comprises forming an optically transparent front side electrode at a front side of each of the plurality of thin-film photovoltaic cells; next, positioning at least one electronic device on the substrate at a lateral edge of the thin-film photovoltaic module, next to the plurality of thin-film photovoltaic cells, wherein the at least one electronic device comprises a first device electrode and a second device electrode and wherein the at least one electronic device comprises a bypass diode, a switch, a DC/DC converter, a capacitor, a transistor, an energy storage device or a load; positioning a first electrically conductive wire above the optically transparent front side electrode of a first thin-film photovoltaic cell, the optically transparent front side electrode of the first thin-film photovoltaic cell having an oblong shape, the first electrically conductive wire being oriented substantially parallel with the oblong direction of the front side electrode of the first thin-film photovoltaic cell such that the first electrically conductive wire overlaps only with the front side electrode of the first thin-film photovoltaic cell and not with the front side electrode of another thin-film photovoltaic cell; positioning a second electrically conductive wire above the optically transparent front side electrode of a second thin-film photovoltaic cell, the optically transparent front side electrode of the second thin-film photovoltaic cell having an oblong shape, the second electrically conductive wire being oriented substantially parallel with the oblong direction of the front side electrode of the second thin-film photovoltaic cell such that the second electrically conductive wire overlaps only with the front side electrode of the second thin-film photovoltaic cell and not with the front side electrode of another thin-film photovoltaic cell; establishing a first electrical connection between the first device electrode and the front side electrode of the first thin-film photovoltaic cell by means of the first electrically conductive wire, over substantially the entire area where the first electrically conductive wire overlays the front side electrode of the first thin-film photovoltaic cell; and establishing a second electrical connection between the second device electrode and the front side electrode of the second thin-film photovoltaic cell by means of the second electrically conductive wire, over substantially the entire area where the second electrically conductive wire overlays the front side electrode of the second thin-film photovoltaic cell. The method may further comprise performing an encapsulation process, thereby encapsulating the plurality of thin-film photovoltaic cells, wherein the encapsulation process comprises a lamination step.

In the method for fabricating a thin-film photovoltaic module according to the second aspect of the present disclosure, establishing the first electrical connection further comprises establishing a first electrical device contact between the first device electrode and the first electrically conductive wire and establishing the second electrical connection further comprises establishing a second electrical device contact between the second device electrode and the second electrically conductive wire.

In embodiments of the method of the second aspect of the present disclosure the at least one electronic device may be positioned over the electrically insulating substrate, which is advantageous in that it may be located at a limited distance from the plurality of thin-film photovoltaic cells, thereby limiting an electrical resistance of the first electrical connection and of the second electrical connection. This is further advantageous in that it enables relatively easy and simple encapsulation of the at least one electronic device simultaneously with the encapsulation of the plurality of thin-thin film photovoltaic cells, by the encapsulation process. However, the present disclosure is not limited thereto. For example, the at least one electronic device may also be located next to the electrically insulating substrate or at the rear side of the electrically insulating substrate, for example in a junction box.

In embodiments of the method of the second aspect of the present disclosure, in particular in embodiments wherein the at least one electronic device is positioned over the electrically insulating substrate, performing the encapsulation process may comprise: providing a layer of encapsulation material fully covering the front side of the plurality of thin-film photovoltaic cells, the at least one electronic device, the first electrically conductive wire and the second electrically conductive wire; providing an optically transparent front encapsulation sheet over the layer of encapsulation material; and performing a lamination step. As a result of the lamination step, the optically transparent front encapsulation sheet is bonded to the electrically insulating substrate, with the plurality of thin-film photovoltaic cells, the at least one electronic device, the first electrically conductive wire and the second electrically conductive wire being sandwiched therein between.

In embodiments of the present disclosure, the first electrically conductive wire and/or the second electrically conductive wire may comprise a solderable material. For example, the first electrically conductive wire and/or the second electrically conductive wire may be made of a solderable material, they may comprise an outer shell made of a solderable material or they may be coated with a solderable material. In such embodiments, establishing the first electrical connection between the first device electrode and the front side electrode of the first thin-film photovoltaic cell may be done simultaneously with the lamination step, and/or establishing the second electrical connection between the second device electrode and the front side electrode of the second thin-film photovoltaic cell may be done simultaneously with the lamination step. In such embodiments, a first electrical contact may be established between the front side electrode of the first thin-film photovoltaic cell and the first electrically conductive wire as a result of the lamination step and/or a second electrical contact may be established between the front side electrode of the second thin-film photovoltaic cell and the second electrically conductive wire as a result of the lamination step. In such embodiments, a first electrical device contact may be established between the first device electrode and the first electrically conductive wire as a result of the lamination step and/or a second electrical device contact may be established between the second device electrode and the second electrically conductive wire as a result of the lamination step. This is advantageous in that the need for performing a separate step for establishing the first electrical contact, the second electrical contact, the first electrical device contact and/or the second electrical device contact may be substantially avoided. This may lead to a reduction of the number of manufacturing steps, a higher throughput, a simplification of the fabrication method, and a reduction of fabrication costs. However, the present disclosure is not limited thereto. For example, in embodiments of the method for fabricating a thin-film photovoltaic module of the present disclosure, the first electrical contact, the second electrical contact, the first device contact and the second device contact may be established by other methods, such as for example by screen printing, welding or soldering, before performing the lamination step.

The method for fabricating a thin-film photovoltaic module of the second aspect of the present disclosure may further comprise forming a plurality of electrically conductive elements above the optically transparent front side electrode of at least part of the plurality of thin-film photovoltaic cells and establishing an electrical contact between the plurality of electrically conductive elements and the underlying front side electrode. The front side electrode and the plurality of electrically conductive elements may have an oblong shape, and the plurality of electrically conductive elements may be oriented with their oblong direction at an angle of at least 60 degrees with respect to the oblong direction of the underlying front side electrode, more preferred at an angle larger than 70 degrees, more preferred at an angle larger than 80 degrees with respect to the oblong direction of the underlying front side electrode. For example, the plurality of electrically conductive elements may be oriented with their oblong direction substantially orthogonal to the oblong direction of the underlying front side electrode. The plurality of electrically conductive elements may for example be provided by screen printing, inkjet printing, plating, sputtering, evaporation, or any other suitable method known by a skilled person.

It is an advantage of embodiments of the method for fabricating a thin-film photovoltaic module of the second aspect of the present disclosure that the method is compatible with industrial fabrication and that manufacturing may be done in a semi-automated or a fully automated way. It is an advantage that labour-intensive and thus expensive manual assembly may be avoided, thus leasing to an industrially viable, relatively low-cost manufacturing technology.

Particular and preferred aspects of the disclosure are set out in the accompanying independent and dependent claims. Features from the dependent claims may be combined with features of the independent claims and with features of other dependent claims as appropriate and not merely as explicitly set out in the claims.

The above and other characteristics, features and advantages of the present disclosure will become apparent from the following detailed description, taken in conjunction with the accompanying drawings, which illustrate, by way of example, the principles of the disclosure. This description is given for the sake of example only, without limiting the scope of the disclosure. The reference figures quoted below refer to the attached drawings.

### Brief description of the figures

FIG 1 schematically illustrates an example of a cross section along the length direction of a thin-film photovoltaic module (prior art).
FIG 2 schematically illustrates an example of a top view of a thin-film photovoltaic module (prior art).
FIG 3 schematically illustrates an example of a top view of a thin-film photovoltaic module in accordance with an embodiment of the first aspect of the present disclosure, showing an electronic device positioned at a lateral edge of the thin-film photovoltaic module and electrical connections of the electronic device with the front side electrodes of a first thin-film photovoltaic cell and of a second thin-film photovoltaic cell.
FIG 4 schematically illustrates an example of a top view of a thin-film photovoltaic module in accordance with an embodiment of the first aspect of the present disclosure, showing a plurality of electronic devices positioned at a lateral edge of the thin-film photovoltaic module and electrical connections of these electronic devices with the front side electrodes of thin-film photovoltaic cells.
FIG 5 schematically illustrates a cross-section along the width direction of a thin-film photovoltaic module according to an embodiment of the first aspect of the present disclosure, at the location of an electrically conductive wire.
FIG 6 schematically illustrates an example of a top view of a thin-film photovoltaic module in accordance with an embodiment of the first aspect of the present disclosure, wherein the thin-film photovoltaic module comprises a plurality of electrically conductive elements in electrical contact with an underlying front side electrode.
FIG 7 schematically illustrates an example of a process flow of a method for fabricating a thin-film photovoltaic module according to the second aspect of the present disclosure.

In the different figures, the same reference signs refer to the same or analogous elements.

### Detailed description

The present disclosure will be described with respect to particular embodiments and with reference to certain drawings, but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the disclosure.

The terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the disclosure described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present disclosure, the only relevant components of the device are A and B.

Reference throughout this specification to "one embodiment" or "an embodiment" means that a particular feature, structure or characteristic described in connection with the embodiment is included in at least one embodiment of the present disclosure. Thus, appearances of the phrases "in one embodiment" or "in an embodiment" in various places throughout this specification are not necessarily all referring to the same embodiment but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the disclosure, various features of the disclosure are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed disclosure requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this disclosure.

Furthermore, while some embodiments described herein include some, but not other features included in other embodiments, combinations of features of different embodiments are meant to be within the scope of the disclosure, and form different embodiments, as would be understood by those in the art. For example, in the following claims, any of the claimed embodiments can be used in any combination.

In the description provided herein, numerous specific details are set forth. However, it is understood that embodiments of the disclosure may be practiced without these specific details. In other instances, well-known methods, structures and techniques have not been shown in detail in order not to obscure an understanding of this description.

The following terms are provided solely to aid in the understanding of the disclosure.

In the context of the present disclosure, a thin film is a thin layer or thin coating having a thickness in the range between 10 nm and 10 micrometers. A thin film photovoltaic cell is a photovoltaic cell wherein the different layers forming the cell are thin layers, typically made by deposition of a stack of thin layers on a substrate such as a glass substrate or a plastic substrate, the present disclosure not being limited thereto. This definition of a thin film photovoltaic cell does not exclude the presence of even thinner layers within the thin film photovoltaic cell structure, such as for example thin passivation layers or tunnel layers, e.g. having a thickness that may be less than 10 nm.

In the context of the present disclosure, a thin-film photovoltaic stack is a stack comprising thin layers forming a thin film photovoltaic cell, wherein the stack comprises at least an active layer or active layer stack for light absorption and charge carrier separation, a first contact layer of a first polarity (first electrode) and a second contact layer of a second polarity (second electrode) opposite to the first polarity. The active layer stack may for example comprise an n-type semiconductor layer and a p-type semiconductor layer. However, additional layers may be included, such as for example an intrinsic semiconductor layer, a hole transporting layer, a hole blocking layer, an electron transporting layer and/or an electron blocking layer, the present disclosure not being limited thereto.

In the context of the present disclosure, a photovoltaic module is a photovoltaic device comprising a plurality of electrically interconnected photovoltaic cells embedded between a back encapsulation sheet, e.g. rear carrier or rear substrate, and a front encapsulation sheet, e.g. front carrier, front cover or superstrate, and further comprising a module frame and external electrical connections, for example for further electrical connection to another photovoltaic module or to a load. A photovoltaic module may further comprise additional elements, such as for example a junction box, a maximum power point tracker and appropriate wiring and electrical connections. These additional elements may for example be integrated within the module frame.

In the context of the present disclosure, a thin-film photovoltaic module is a photovoltaic module comprising a plurality of thin-film photovoltaic cells that are electrically interconnected, e.g. electrically connected in series. The plurality of electrically connected photovoltaic cells is typically monolithically integrated on a substrate. In the context of the present disclosure, a thin-film photovoltaic module may for example comprise thin-film photovoltaic cells based on chalcogenide materials such as CdTe (Cadmium Telluride), CIS (Copper Indium Selenide), CGS (Copper Gallium Selenide), CIGS (Copper Indium Gallium Selenide, Copper Indium Gallium Sulfide), e.g. kesterites such as CZTS (Copper Zinc Tin Sulfide, Copper Zinc Tin Selenide), organic materials or perovskite materials, the present disclosure not being limited thereto.

In the context of the present disclosure, the front surface or front side of a photovoltaic cell or of a photovoltaic module is the surface or side adapted for being oriented towards a light source and thus for receiving illumination. In case of bifacial photovoltaic cells or modules, both surfaces are adapted to receive impinging light. In such case, the front surface or front side is the surface or side adapted for receiving the largest fraction of the light or illumination. The back surface, rear surface, back side or rear side of a photovoltaic cell or a photovoltaic module is the surface or side opposite to the front surface or side.

In the context of the present disclosure, the term 'wire' refers to a feature having a length that is substantially larger than its width. For example, the term 'wires' also includes ribbons, threads, rods, lines, stripes and strips, the present disclosure not being limited thereto.

The disclosure will now be described by a detailed description of several embodiments of the disclosure. It is clear that other embodiments of the disclosure can be configured according to the knowledge of persons skilled in the art, the disclosure being limited only by the terms of the appended claims.

In a first aspect, the present disclosure relates to thin-film photovoltaic modules comprising at least one integrated electronic device.

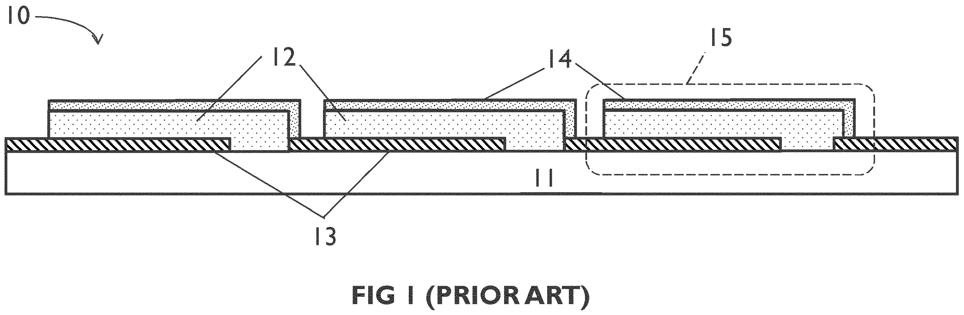

FIG 1 schematically illustrates an example of a cross section of a (part of) a thin-film photovoltaic module 10, along the length direction of the module. The thin-film photovoltaic module shown in FIG 1 comprises a substrate 11 on which a plurality of patterned layers is provided, more in particular a first patterned layer forming a plurality of first cell electrodes 13, a second patterned layer forming a plurality of cell active layers 12 and a third patterned layer forming a plurality of second cell electrodes 14, the plurality of second cell electrodes 14 having a polarity opposite to a polarity of the plurality of first cell electrodes 13. Each stack comprising a first cell electrode 13, a cell active layer 12 and a second cell electrode 14 forms a thin-film photovoltaic cell 15.

In embodiments of the present disclosure, the substrate 11 is an electrically insulating substrate. The substrate 11 may for example be a glass substrate, a plastic substrate such as a plastic foil, or a composite substrate, the present disclosure not being limited to such electrically insulating substrates.

In the example shown in FIG 1, the patterned layers 12, 13, 14 form a plurality of thin-film photovoltaic cells 15 that are electrically connected in series. The series connection of the plurality of thin-film photovoltaic cells 15 is obtained by establishing, for each thin-film photovoltaic cell 15, an electrical connection between the first cell electrode 13 of the thin-film photovoltaic cell and the second cell electrode 14 of a neighbouring thin-film photovoltaic cell. The plurality of first cell electrodes 13 is provided on the substrate 11 and may comprise any suitable electrically conductive material, for example a metal, such as copper, gold, silver, molybdenum or platinum, a metal alloy, an electrically conductive oxide or an electrically conductive polymer. The active layer 12 is patterned to form the plurality of photovoltaic cells 15. It may comprise more than one thin-film layer, for example a plurality of stacked layers, i.e. the active layer 12 may be a stack comprising a plurality of thin-film layers. It comprises at least a first thin film semiconductor layer having the function of an absorber layer wherein light can be absorbed and wherein electrons and holes can be generated upon light absorption. The absorber layer may for example be a layer comprising a chalcogenide semiconductor material such as e.g. CdTe (Cadmium Telluride), CIS (Copper Indium Selenide), CGS (Copper Gallium Selenide), CIGS (Copper Indium Gallium Selenide, Copper Indium Gallium Sulfide), e.g. a kesterite such as CZTS (Copper Zinc Tin Sulfide, Copper Zinc Tin Selenide), or a layer comprising an organic material or a perovskite material. The active layer 12 may further comprise a second thin film semiconductor layer forming a homojunction or a hetero-junction with the first thin film semiconductor layer, enabling separation of light-generated charge carriers. The active layer may comprise a single junction or it may comprise more than one junction (tandem cell). The active layer 12 may further comprise a charge transport layer (a hole transport layer and/or an electron transport layer), for example for facilitating charge transport towards the first cell electrode 13 and/or towards the second cell electrode 14. The active layer 12 may further comprise a charge injection layer (a hole injection layer and/or an electron injection layer), for example for reducing a contact resistance between the active layer 12 and the first cell electrode 13 and/or for reducing a contact resistance between the active layer 12 and the second cell electrode 14.

In embodiments according to the present disclosure the plurality of thin-film photovoltaic cells 15 is oriented with a rear side oriented towards the electrically insulating substrate 11. Therefore, to allow incident light entering into the active layer for being absorbed, the plurality of second cell electrodes 14 is optically transparent for wavelengths that may be absorbed by the absorber layer. The plurality of second cell electrodes 14 may comprise any suitable transparent electrically conductive material, for example an electrically conductive oxide (e.g. TCO, Transparent Conductive Oxide) or an electrically conductive polymer. Examples of TCO materials that may be used are Indium Tin Oxide and Zinc Oxide, the present disclosure not being limited thereto.

As illustrated in the example shown in FIG 1, each second cell electrode 14 is electrically connected to the first cell electrode 13 of a neighbouring photovoltaic cell, such that all photovoltaic cells 15 provided on the substrate 11 are electrically connected in series.

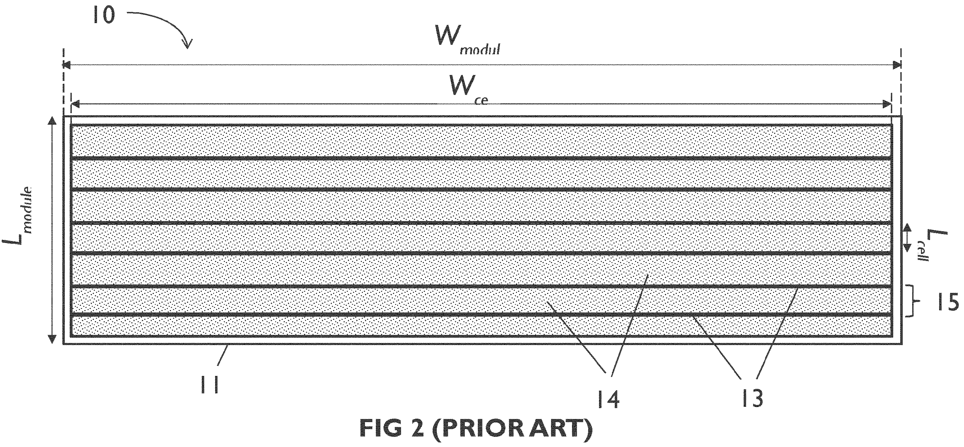

FIG 2 schematically illustrates an example of a top view of a thin-film photovoltaic module 10. In the example shown, the active layer 12 is patterned to form rectangular shaped thin-film photovoltaic cells 15 having a cell width *W_{cell}.* The cell width *W_{cell}* may be substantially equal to the width of the module, *W_{module}.* Preferably the cell width *W_{cell}* is slightly smaller than the width of the module, *W_{module},* as schematically illustrated in FIG 2, such as for example a few centimetres smaller. This allows e.g. module edge sealing and framing without causing shading losses. The plurality of thin-film photovoltaic cells 15 have a cell length *L_{cell}.* They are electrically connected in series in a direction corresponding to the cell length, resulting in a thin-film photovoltaic module having a module length *L_{module}.*

In a thin-film photovoltaic module, the cell width *W_{cell}* may be substantially larger than the cell length *L_{cell}.* For example, the cell length is typically in the range between 3 mm and 50 mm and the cell width is typically in the range between 50 cm and 160 cm. The number of thin-film photovoltaic cells connected in series may for example be in the range between 60 and 100, typically resulting in a thin-film photovoltaic module having a module length e.g. in the range between 30 cm and 90 cm and a module width in the range between 50 cm and 160 cm.

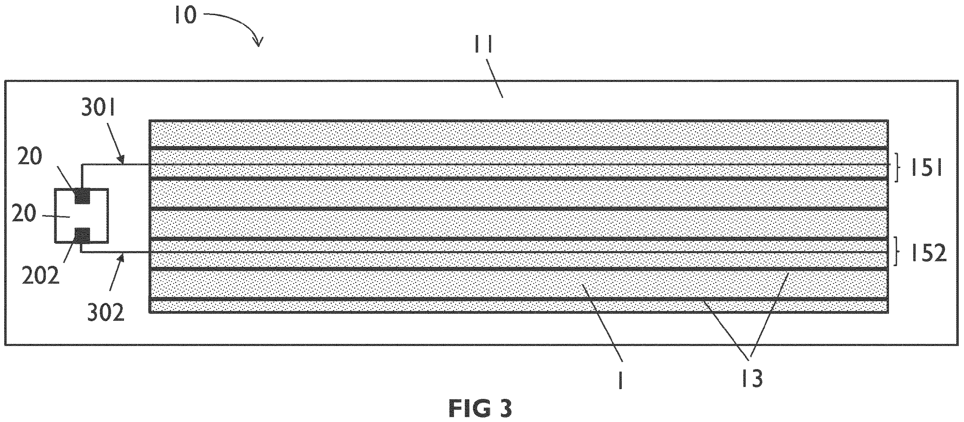

FIG 3 schematically illustrates an example of a top view of a thin-film photovoltaic module in accordance with an embodiment of the present disclosure. The thin-film photovoltaic module 10 comprises a plurality of thin-film photovoltaic cells and an electronic device 20 positioned at a lateral edge of the thin-film photovoltaic module 10. In the example shown (not drawn on scale), the electronic device 20 is positioned on the substrate 11, next to the active area of the thin-film photovoltaic module, i.e. next to the plurality of photovoltaic cells. The electronic device 20 comprises a first device electrode 201 and a second device electrode 202. The first device electrode 201 may for example be an input electrode of the device and the second device electrode 202 may for example be an output electrode of the device, or vice versa. The first device electrode 201 may for example have a first polarity and the second device electrode 202 may for example have a second polarity opposite to the first polarity. The first device electrode 201 is electrically connected to the second cell electrode 14 (front side electrode 14) of a first thin-film photovoltaic cell 151 by means of a first electrically conductive wire 301. The second device electrode 202 is electrically connected to the second cell electrode 14 (front side electrode 14) of a second thin-film photovoltaic cell 152 by means of a second electrically conductive wire 302.

As illustrated in FIG 3, the electronic device 20 may bridge a plurality of thin-film photovoltaic cells, i.e. the first thin-film photovoltaic cell 151 and the second thin-film photovoltaic cell 152 to which the electronic device is connected are not located next to each other but there are a plurality of thin-film photovoltaic cells in between the first thin-film photovoltaic cell and the second thin-film photovoltaic cell. For example, the number of bridged cells may be in the range between 5 and 20.

In advantageous embodiments of a thin-film photovoltaic module of the present disclosure, the first and second electrically conductive wires 301, 302 have an electrical resistance that is substantially lower than the electrical resistance of the front side electrode 14 of the thin-film photovoltaic cells 15. This may lead to a substantial reduction of the electrical resistance of the electrical current path between the thin-film photovoltaic cells 15 and the electronic device 20, and thus in a substantial reduction of resistive losses (e.g. when conducting a current between the thin-film photovoltaic cells 15 and the electronic device 20, e.g. when draining a current from the thin-film photovoltaic cells 15 to the electronic device 20). For example, the first electrically conductive wire and the second electrically conductive wire may be metal wires such as cupper wires or aluminium wires, the present disclosure not being limited thereto. Further, additional shading effects due to the presence of the first and second electrically conductive wires 301, 302 at a front side of the thin-film photovoltaic module are preferably limited, such that additional optical losses due to their presence are sufficiently low. This may lead to a trade-off between a sufficiently low electrical resistance of the current path between the thin-film photovoltaic cells and the electronic device, such as for example an electrical resistance lower than 2 Ohm, preferably lower than 1 Ohm and a sufficiently low shading effect of the electrically conductive wires, such as for example less than 3% shading, preferably less than 1% shading.

In embodiments of a thin-film photovoltaic module of the present disclosure, the first electrically conductive wire 301 causes shading of the first thin-film photovoltaic cell 151 and the second electrically conductive wire 302 causes shading of the second thin-film photovoltaic cell 152. Although these shading effects are rather limited (for example less than 3%, preferably less than 1% of the underlying thin-film photovoltaic cell), they affect not only the electrical current through the thin-film photovoltaic cells covered by a wire but also the electrical current through thin-film photovoltaic cells not covered by a wire. This is related to the plurality of thin-film photovoltaic cells being electrically connected in series, which implies a substantially equal electrical current through all connected thin-film photovoltaic cells. In order to compensate for this effect or to alleviate this effect, the thin-film photovoltaic module may comprise thin-film photovoltaic cells of two different lengths. The thin-film photovoltaic cells not covered by a wire may have a first length and the thin-film photovoltaic cells covered by a wire may have a second length, wherein the second length is substantially equal to the sum of the first length and the width of the wire. This results in an exposed area (i.e. non-shaded area) that is substantially equal for all photovoltaic cells.

In embodiments of a thin-film photovoltaic module 10 of the present disclosure, the first and second electrically conductive wires 301, 302 may be metal wires (e.g. copper wires, aluminium wires, ...). In embodiments the first and second electrically conductive wires 301, 302 may comprise a solder coating, for example a low temperature solder coating. The electrically conductive wires may for example have a circular cross section. A sufficiently low electrical resistance and simultaneously a sufficiently low shading effect may for example be obtained for such wires with a diameter in the range between 20 micrometer and 200 micrometer. However, the present disclosure is not limited thereto, and the first and second electrically conductive wires 301, 302 may have a cross section different from a circular cross section, such as for example a rectangular cross section.

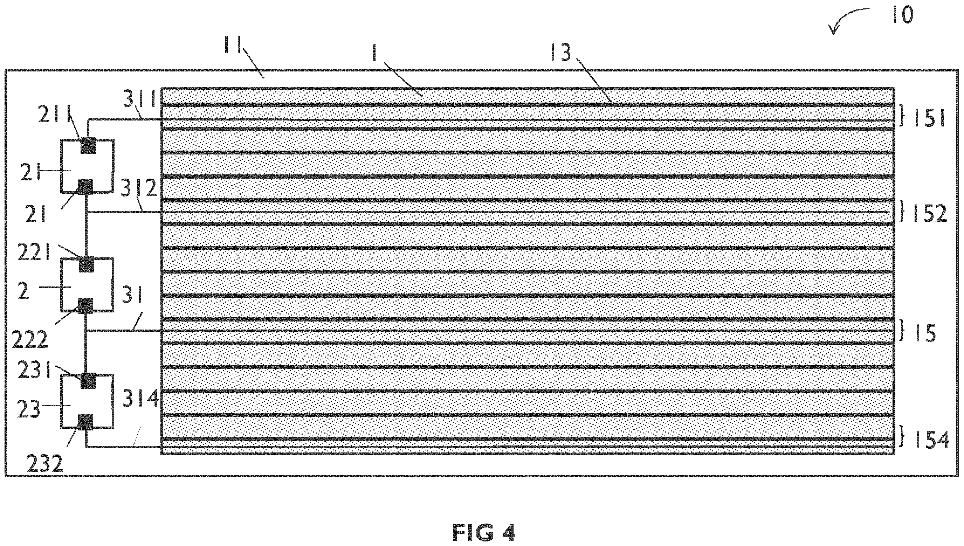

In the example illustrated in FIG 3 only one electronic device 20 is shown. However, the present disclosure is not limited thereto, and a plurality of electronic devices may be integrated at a lateral edge of the thin-film photovoltaic module 10, as schematically illustrated in FIG 4. FIG 4 illustrates an example of a thin-film photovoltaic module 10 comprising three integrated electronic devices. A first electronic device 21 comprises a first device electrode 211 and a second device electrode 212. The first device electrode 211 is electrically connected to the second cell electrode 14 (front side electrode 14) of a first thin-film photovoltaic cell 151 by means of electrically conductive wire 311. The second device electrode 212 is electrically connected to the second cell electrode 14 (front side electrode 14) of a second thin-film photovoltaic cell 152 by means of electrically conductive wire 312. A second electronic device 22 comprises a first device electrode 221 and a second device electrode 222. The first device electrode 221 is electrically connected to the second cell electrode 14 (front side electrode 14) of the second thin-film photovoltaic cell 152 by means of electrically conductive wire 312. The second device electrode 222 is electrically connected to the second cell electrode 14 (front side electrode 14) of a third thin-film photovoltaic cell 153 by means of electrically conductive wire 313. A third electronic device 23 comprises a first device electrode 231 and a second device electrode 232. The first device electrode 231 is electrically connected to the second cell electrode 14 (front side electrode 14) of the third thin-film photovoltaic cell 153 by means of electrically conductive wire 313. The second device electrode 232 is electrically connected to the second cell electrode 14 (front side electrode 14) of a fourth thin-film photovoltaic cell 154 by means of electrically conductive wire 314.

In embodiments of the present disclosure wherein the thin-film photovoltaic module 10 comprises a plurality of integrated electronic devices 20, 21, 22, 23, the plurality of integrated electronic devices may be positioned at a single lateral edge of the module, as for example illustrated in FIG 4. In embodiments of the present disclosure wherein the thin-film photovoltaic module 10 comprises a plurality of integrated electronic devices 20, 21 22, 23, the plurality of integrated electronic devices 20 may be positioned at more than one lateral edge of the thin-film photovoltaic module, such as for example at two opposite lateral edges or at three lateral edges or at the four lateral edges.

In the examples illustrated in FIG 3 and FIG 4, the electrically conductive wires 301, 302, 311, 312, 313, 314 are oriented substantially parallel to the oblong direction of the plurality of (rectangular) front side electrodes 14. In embodiments of the present disclosure, the electrically conductive wires may also be oriented at an angle, preferably a slight angle, with the oblong direction of the front side electrodes 14. This angle is preferably limited such that each electrically conductive wire is located on a single front side electrode 14, i.e. such that each electrically conductive wire only overlays a single front side electrode 14. Limiting the angle is advantageous in that it may substantially reduce a risk of creating electrical short-cuts between thin-film photovoltaic cells.

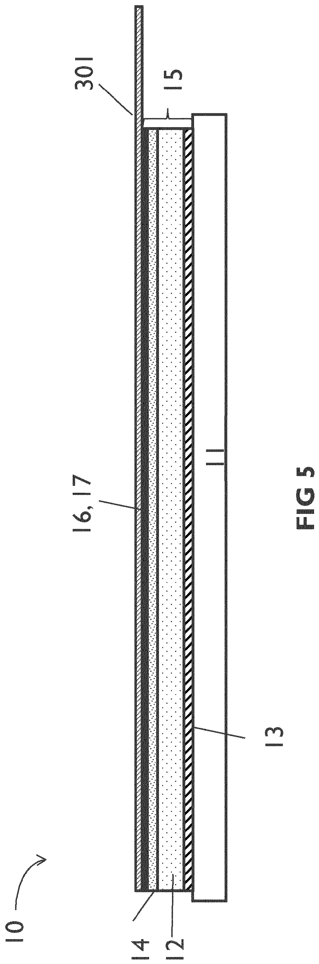

In embodiments of a thin-film photovoltaic module of the present disclosure an electrical contact may be established between an electrically conductive wire and the corresponding front side electrode over substantially the entire area where the electrically conductive wire overlays the corresponding front side electrode. This is schematically illustrated in FIG 5, showing a cross-section along the width direction of a thin-film photovoltaic module 10 according to an embodiment of the present disclosure, at the location of an electrically conductive wire 301. In the example illustrated in FIG 5, the electrically conductive wire 301 overlays the front side electrode 14 of the thin-film photovoltaic cell 15 over substantially the entire cell width. However, the present disclosure is not limited thereto and the electrically conductive wire 301 may overlay the first electrode only in a part of the cell width. In the example shown in FIG 5, an electrically conductive material 16 establishing an electrical contact between the electrically conductive wire 301 and the underlying front side electrode 14 is present in between the electrically conductive wire 301 and the front side electrode 14 over substantially the entire cell width, i.e. over substantially the entire area wherein the electrically conductive wire 301 overlays the front side electrode 14. The electrical contact is thereby established over substantially the entire area where the electrically conductive wire 301 overlays the front side electrode 14. However, the present disclosure is not limited thereto, and an electrically conductive material may be provided only in part of the area where the electrically conductive wire 301 overlays the front side electrode 14.

In the example illustrated in FIG 5, an electrical contact 17 is established by providing an electrically conductive material 16 between the electrically conductive wire 301 and the underlying front side electrode 14. However, the present disclosure is not limited thereto, and the electrical contact 17 may also be established without providing such electrically conductive material 16 in between. For example, the electrically conductive wire 301 may comprise a solder coating and the electrical contact 17 may be established by soldering.

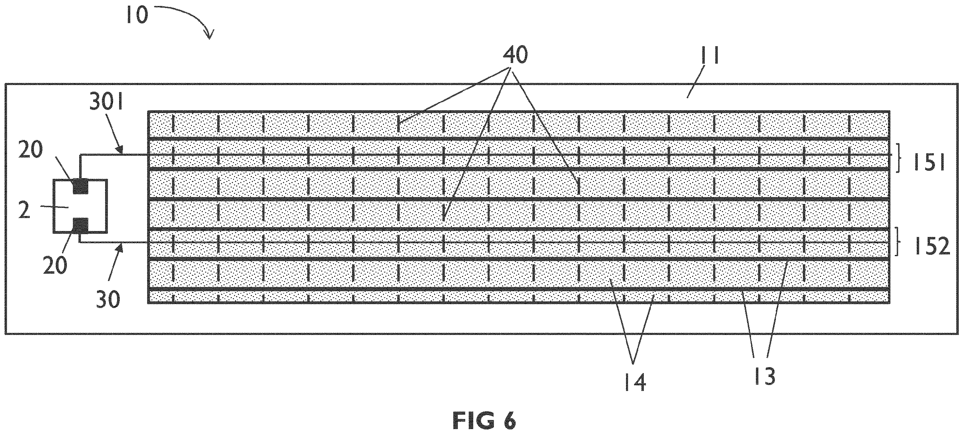

In embodiments of the present disclosure, the thin-film photovoltaic module may comprise a plurality of electrically conductive elements on the optically transparent front side electrode of at least part of the plurality of thin-film photovoltaic cells, wherein the plurality of electrically conductive elements is in electrical contact with the underlying front side electrode, wherein the front side electrode and the plurality of electrically conductive elements have an oblong shape and wherein the plurality of electrically conductive elements is oriented with their oblong direction at an angle of at least 60 degrees with respect to the oblong direction of the underlying front side electrode, more preferred at an angle larger than 70 degrees, more preferred at an angle larger than 80 degrees with respect to the oblong direction of the underlying front side electrode. Preferably the plurality of electrically conductive elements is oriented with their oblong direction substantially orthogonal to the oblong direction of the underlying front side electrode. Preferably the plurality of electrically conductive elements is positioned at spaced locations, these spaced locations being spread over the underlying front side electrode. This is schematically illustrated in FIG 6.

FIG 6 schematically illustrates an example of a top view of a thin-film photovoltaic module 10 in accordance with an embodiment of the present disclosure, showing an electronic device 20 positioned at a lateral edge of the thin-film photovoltaic module 10, wherein the thin-film photovoltaic module 10 comprises a plurality of electrically conductive elements 40 in electrical contact with an underlying front side electrode 14. A first device electrode 201 of the electronic device 20 is electrically connected to the front side electrode 14 of a first thin-film photovoltaic cell 151 by means of a first electrically conductive wire 301. A first electrical contact between the first electrically conductive wire 301 and the front side electrode of the first thin-film photovoltaic cell 151 may be established through the plurality of electrically conductive elements 40 located on the front side electrode 14 of the first thin-film photovoltaic cell 151. An electrical contact may also be established directly between the first electrically conductive wire 301 and the front side electrode of the first thin-film photovoltaic cell 151. A second device electrode 202 of the electronic device 20 is electrically connected to the front side electrode 14 of a second thin-film photovoltaic cell 152 by means of a second electrically conductive wire 302. A second electrical contact between the second electrically conductive wire 302 and the front side electrode of the second thin-film photovoltaic cell 152 may be established through the plurality of electrically conductive elements 40 located on the front side electrode 14 of the second thin-film photovoltaic cell 152. An electrical contact may also be established directly between the second electrically conductive wire 302 and the front side electrode of the second thin-film photovoltaic cell 152.

A thin-film photovoltaic module 10 comprising a plurality of electrically conductive elements 40 as for example illustrated in FIG 6 may have an increased cell length, without substantially increasing the electrical series resistance. It is an advantage of an increased cell length that, for a given thin-film photovoltaic module size, the number of series-connected thin-film photovoltaic cells is reduced, which may lead to a reduction of losses in active area due to the series connection of the cells. It is an advantage that this results in an increase of the active area for a given thin-film photovoltaic module size and thus in an increased energy generation per unit area. On the other hand, the plurality of electrically conductive elements 40 create additional shading effects on the underlying thin-film photovoltaic cells. Therefore, preferably a compromise or balance is made between the positive effects of an increased active area and the negative effects of additional shading.

In a second aspect, the present disclosure relates to fabrication methods for thin-film photovoltaic modules according to the first aspect.

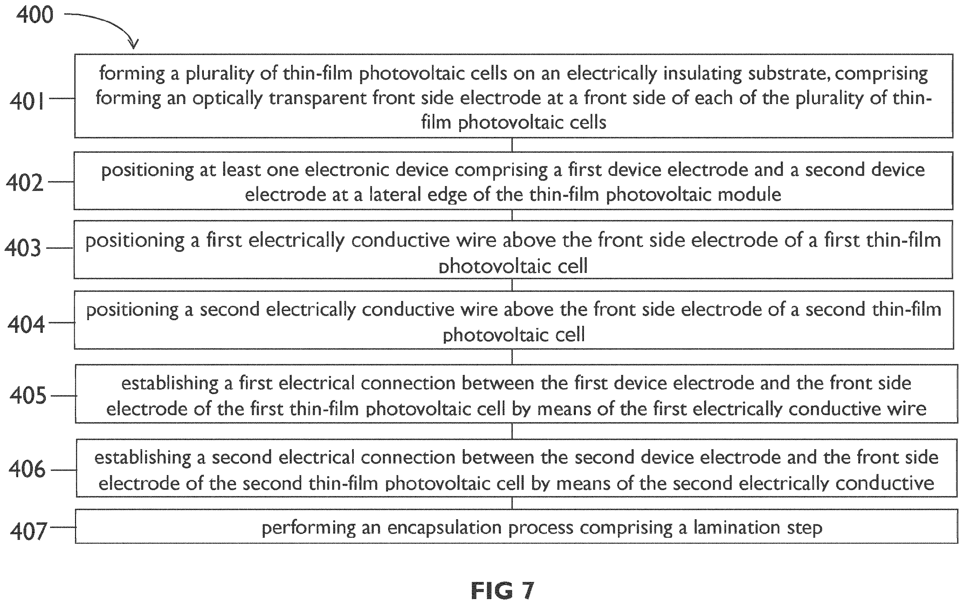

An example of a method 400 for fabricating a thin-film photovoltaic module according to the second aspect of the present disclosure is schematically illustrated in the process flow of FIG 7.

In the example of a method 400 illustrated in FIG 7, a plurality of series-connected thin-film photovoltaic cells is formed (FIG 7, step 401) on an electrically insulating substrate with a rear side of the plurality of thin-film photovoltaic cells oriented towards the substrate. Forming the plurality of series-connected thin-film photovoltaic cells comprises forming an optically transparent front side electrode at a front side of each of the plurality of thin-film photovoltaic cells.

A next step comprises positioning (FIG 7, step 402) at least one electronic device at a lateral edge of the thin-film photovoltaic module, such as for example on the electrically insulating substrate. The at least one electronic device comprises a first device electrode and a second device electrode.

The method 400 further comprises positioning (FIG 7, step 403) a first electrically conductive wire above the optically transparent front side electrode of a first thin-film photovoltaic cell and positioning (FIG 7, step 404) a second electrically conductive wire above the optically transparent front side electrode of a second thin-film photovoltaic cell; establishing (FIG 7, step 405) a first electrical connection between the first device electrode and the front side electrode of the first thin-film photovoltaic cell by means of the first electrically conductive wire and establishing (FIG 7, step 406) a second electrical connection between the second device electrode and the front side electrode of the second thin-film photovoltaic cell by means of the second electrically conductive wire.

Establishing the first electrical connection between the first device electrode and the front side electrode of the first thin-film photovoltaic cell comprises establishing a first electrical contact between the front side electrode of the first thin-film photovoltaic cell and the first electrically conductive wire and establishing a first electrical device contact between the first device electrode and the first electrically conductive wire. Establishing the second electrical connection between the second device electrode and the front side electrode of the second thin-film photovoltaic cell comprises establishing a second electrical contact between the front side electrode of the second thin-film photovoltaic cell and the second electrically conductive wire and establishing a second electrical device contact between the second device electrode and the second electrically conductive wire.

In embodiments of a method 400 for fabricating a thin-film photovoltaic module according to the second aspect of the present disclosure, establishing the first electrical device contact between the first device electrode and the first electrically conductive wire and/or establishing the second electrical device contact between the second device electrode and the second electrically conductive wire may for example comprise soldering, welding, printing (e.g. screen printing), gluing, pressing, printing of an electrically conductive structure, welding of an electrically conductive structure or soldering of an electrically conductive structure or any combination thereof.

In embodiments of a method 400 for fabricating a thin-film photovoltaic module according to the second aspect of the present disclosure, establishing the first electrical contact between the first electrically conductive wire and the front side electrode of the first thin-film photovoltaic cell and establishing the second electrical contact between the second electrically conductive wire and the front side electrode of the second thin-film photovoltaic cell may for example comprise soldering, welding, printing (e.g. screen printing), gluing, pressing, wire bonding, printing of an electrically conductive structure, welding of an electrically conductive structure or soldering of an electrically conductive structure or any combination thereof.

A method for fabricating a thin-film photovoltaic module according to the second aspect may further comprise performing (FIG 7, step 407) an encapsulation process, wherein the encapsulation process comprises a lamination step. The encapsulation process may comprise providing a layer of encapsulation material, such as for example a layer comprising EVA, PVB, Polyolefin or a silicone. Next, an optically transparent plate covering the encapsulation material may be provided, and afterwards a lamination step may be performed. In embodiments of a method 400 for fabricating a thin-film photovoltaic module, in particular in embodiments wherein the at least one electronic device is positioned over the electrically insulating substrate, the layer of encapsulation material preferably fully covers the front side of the plurality of thin-film photovoltaic cells, the at least one electronic device, the first electrically conductive wire and the second electrically conductive wire.

The lamination step typically comprises heating, to induce flowing of the encapsulation material. In advantageous embodiments of a method 400 for fabricating a thin-film photovoltaic module according to the second aspect of the present disclosure, the first electrically conductive wire and the second electrically conductive wire may comprise a solderable material or a solderable coating. For example, the first electrically conductive wire and the second electrically conductive wire may be made of a solderable material or they may be at least partially coated with a solderable material, for example a material that is solderable at low temperature (for example at a temperature in the range between 150°C and 200°C). In such embodiments the heating performed during the lamination step may result in the formation of the first electrical connection and/or the second electrical connection, or at least part of the first electrical connection and/or the second electrical connection, by soldering. For example, establishing the first electrical contact between the first electrically conductive wire and the front side electrode of the first thin-film photovoltaic cell and/or establishing the second electrical contact between the second electrically conductive wire and the second thin-film photovoltaic cell may be done simultaneously with the lamination step. For example, establishing the first electrical device contact between the first device electrode and the first electrically conductive and/or establishing the second electrical device contact between the second device electrode and the second electrically conductive wire may be done simultaneously with the lamination step. In such embodiments, performing the heating process may comprise performing a heating process comprising a first phase at a first temperature and a second phase at a second temperature, the second temperature being higher than the first temperature. The first temperature may be selected to enable soldering, to thereby form the electrical connections. The second temperature may be selected to enable melting of the encapsulation material. For example, the first temperature may be in the range between 120°C and 240°C, preferably between 140°C and 160°C, and the second temperature may be 5°C to 50°C higher than the first temperature, the present disclosure not being limited thereto.

A method for fabricating a thin-film photovoltaic module according to the second aspect of the present disclosure may further comprise forming a plurality of electrically conductive elements above the optically transparent front side electrode of at least part of the plurality of thin-film photovoltaic cells and establishing an electrical contact between the plurality of electrically conductive elements and the underlying front side electrode. In such embodiments the front side electrode and the plurality of electrically conductive elements preferably have an oblong shape and the plurality of electrically conductive elements is preferably oriented with their oblong direction at an angle of at least 60 degrees with respect to the oblong direction of the underlying front side electrode, more preferred at an angle larger than 70 degrees, more preferred at an angle larger than 80 degrees with respect to the oblong direction of the underlying front side electrode. For example, the plurality of electrically conductive elements may be oriented with their oblong direction substantially orthogonal to the oblong direction of the underlying front side electrode. The plurality of electrically conductive elements may be formed at spaced locations, these spaced locations being spread over the underlying front side electrode.

Forming the plurality of electrically conductive elements may for example comprise screen printing (e.g. of a silver paste), inkjet printing, sputtering through a shadow mask or plating, the present disclosure not being limited thereto.

A method for fabricating a thin-film photovoltaic module according to the second aspect of the present disclosure may comprise additional steps (not shown in FIG 7), such as for example providing busbars, edge sealing, framing, providing electrical connection leads, and junction box connection and integration.

The foregoing description details certain embodiments of the disclosure. It will be appreciated, however, that no matter how detailed the foregoing appears in text, the disclosure may be practiced in many ways. It should be noted that the use of particular terminology when describing certain features or aspects of the disclosure should not be taken to imply that the terminology is being re-defined herein to be restricted to including any specific characteristics of the features or aspects of the disclosure with which that terminology is associated.

It is to be understood that although preferred embodiments, specific constructions and configurations, as well as materials, have been discussed herein for devices according to the present disclosure, various changes or modifications in form and detail may be made without departing from the scope of this invention as defined by the claims. For example, steps may be added or deleted to methods described as long as they fall within the scope of the claims.

## Claims

1. A thin-film photovoltaic module (10) comprising:
a plurality of thin-film photovoltaic cells (15, 151, 152, 153, 154), each of the thin-film photovoltaic cells having a cell length and a cell width,
wherein the plurality of thin-film photovoltaic cells (15, 151, 152, 153, 154) is formed on an electrically insulating substrate (11) with a rear side of the plurality of thin-film photovoltaic cells (15, 151, 152, 153, 154) oriented towards the electrically insulating substrate (11);
wherein each of the plurality of thin-film photovoltaic cells (15, 151, 152, 153, 154) has an optically transparent front side electrode (14) at a front side opposite to the rear side;
wherein the plurality of thin-film photovoltaic cells (15, 151, 152, 153, 154) is electrically connected in series in a direction corresponding to the cell length; and;
at least one electronic device (20, 21, 22, 23) comprising a first device electrode (201, 211, 221, 231) and a second device electrode (202, 212, 222, 232),
wherein the at least one electronic device (20, 21, 22, 23) comprises a bypass diode, a switch, a DC/DC converter, a capacitor, a transistor, an energy storage device or a load;
wherein the at least one electronic device (20, 21, 22, 23) is positioned on the substrate (11) at a lateral edge of the thin-film photovoltaic module (10), next to the plurality of thin-film photovoltaic cells (15, 151, 152, 153, 154);
wherein the first device electrode (201, 211, 221, 231) is electrically connected to the front side electrode (14) of a first thin-film photovoltaic cell (151, 152, 153) by means of a first electrically conductive wire (301, 311, 312, 313),
wherein the second device electrode (202, 212, 222, 232) is electrically connected to the front side electrode (14) of a second thin-film photovoltaic cell (152, 153, 154) by means of a second electrically conductive wire (302, 312, 313, 314), and
wherein the first electrically conductive wire (301, 311, 312, 313) overlays the front side electrode (14) of the first thin-film photovoltaic cell (151, 152, 153) and wherein the second electrically conductive wire (302, 312, 313, 314) overlays the front side electrode (14) of the second thin-film photovoltaic cell (152, 153, 154).
wherein the optically transparent front side electrode (14) of the plurality of thin-film photovoltaic cells (15, 151, 152, 153, 154) has an oblong shape, and wherein the first electrically conductive wire (301, 311, 312, 313) is oriented substantially parallel with the oblong direction of the front side electrode (14) of the first thin-film photovoltaic cell (151, 152, 153) such that the first electrically conductive wire overlaps only with the front side electrode of the first thin-film photovoltaic cell and not with the front side electrode of another thin-film photovoltaic cell and the second electrically conductive wire (302, 312, 313, 314) is oriented substantially parallel with the oblong direction of the front side electrode (14) of the second thin-film photovoltaic cell (152, 153, 154) such that the second electrically conductive wire overlaps only with the front side electrode of the second thin-film photovoltaic cell and not with the front side electrode of another thin-film photovoltaic cell,
and wherein the electrical contact between the first electrically conductive wire (301, 311, 312, 313) and the front side electrode (14) of the first thin-film photovoltaic cell (151, 152, 153) and between the second electrically conductive wire (302, 312, 313, 314) and the front side electrode (14) of the second thin-film photovoltaic cell (152, 153, 154) is established over substantially the entire area where the electrically conductive wire overlays the corresponding front side electrode.

2. The thin-film photovoltaic module (10) according to claim 1, wherein the first electrically conductive wire (301, 311, 312, 313) has an electrical resistance that is substantially lower than an electrical resistance of the front side electrode (14) of the first thin-film photovoltaic cell (151, 152, 153) and wherein the second electrically conductive wire (302, 312, 313, 314) has an electrical resistance that is substantially lower than an electrical resistance of the front side electrode (14) of the second thin-film photovoltaic cell (152, 153, 154).

3. The thin-film photovoltaic module according (10) to claim 1 or claim 2, wherein the plurality of thin-film photovoltaic cells (15, 151, 152, 153, 154) is monolithically integrated on the electrically insulating substrate.

4. The thin-film photovoltaic module (10) according to any of the previous claims, wherein the thin-film photovoltaic module (10) comprises a first electrical contact (17) between the front side electrode (14) of the first thin-film photovoltaic cell (151, 152, 153) and the first electrically conductive wire (301, 311, 312, 313), wherein the first electrical contact (17) extends over a substantial part of the first front side electrode (14) along the width direction of the first thin-film photovoltaic cell (151, 152, 153), and wherein the thin-film photovoltaic module (10) comprises a second electrical contact (17) between the front side electrode (14) of the second thin-film photovoltaic cell (152, 153, 154) and the second electrically conductive wire (302, 312, 313, 314), wherein the second electrical contact (17) extends over a substantial part of the second front side electrode (14) along the width direction of the second thin-film photovoltaic cell (152, 153, 154).

5. The thin-film photovoltaic module (10) according to any of the previous claims, further comprising a plurality of electrically conductive elements (40) above the optically transparent front side electrode (14) of at least part of the plurality of thin-film photovoltaic cells (15, 151, 152, 153, 154), wherein the plurality of electrically conductive elements (40) is in electrical contact with the underlying front side electrode (14), wherein the front side electrode (14) and the plurality of electrically conductive elements (40) have an oblong shape and wherein the plurality of electrically conductive elements (40) is oriented with their oblong direction at an angle of at least 60 degrees with respect to the oblong direction of the underlying front side electrode (14).

6. The thin-film photovoltaic module (10) according to claim 5, wherein the plurality of electrically conductive elements (40) is oriented with their oblong direction substantially orthogonal to the oblong direction of the underlying front side electrode (14).

7. The thin-film photovoltaic module (10) according to any of the previous claims, wherein the at least one electronic device (20, 21, 22, 23) bridges a plurality of thin-film photovoltaic cells (15) connected in series between the first thin-film photovoltaic cell (151, 152, 153) and the second photovoltaic cell (152, 153, 154), the number of bridged thin-film photovoltaic cells (15) being in the range between 5 and 20.

8. A method (400) for fabricating a thin-film photovoltaic module (10), the method comprising:
first forming (401) a plurality of series-connected thin-film photovoltaic cells (15, 151, 152, 153, 154) on an electrically insulating substrate (11) with a rear side of the plurality of thin-film photovoltaic cells (15, 151, 152, 153, 154) oriented towards the substrate (11), wherein forming the plurality of series-connected thin-film photovoltaic cells (15, 151, 152, 153, 154) comprises forming an optically transparent front side electrode (14) at a front side of each of the plurality of thin-film photovoltaic cells (15, 151, 152, 153, 154);
next, positioning (402) at least one electronic device (20, 21, 22, 23) on the substrate (11) at a lateral edge of the thin-film photovoltaic module (10), next to the plurality of thin-film photovoltaic cells (15, 151, 152, 153, 154), wherein the at least one electronic device (20, 21, 22, 23) comprises a first device electrode (201, 211, 221, 231) and a second device electrode (202, 212, 222, 232) and wherein the at least one electronic device (20, 21, 22, 23) comprises a bypass diode, a switch, a DC/DC converter, a capacitor, a transistor, an energy storage device or a load;
positioning (403) a first electrically conductive wire (301, 311, 312, 313) above the optically transparent front side electrode (14) of a first thin-film photovoltaic cell (151, 152, 153), the optically transparent front side electrode (14) of the first thin-film photovoltaic cell (151, 152, 153) having an oblong shape, the first electrically conductive wire (301, 311, 312, 313) being oriented substantially parallel with the oblong direction of the front side electrode (14) of the first thin-film photovoltaic cell (151, 152, 153) such that the first electrically conductive wire overlaps only with the front side electrode of the first thin-film photovoltaic cell and not with the front side electrode of another thin-film photovoltaic cell;
positioning (404) a second electrically conductive wire (302, 312, 313, 314) above the optically transparent front side electrode (14) of a second thin-film photovoltaic cell (152, 153, 154), the optically transparent front side electrode (14) of the second thin-film photovoltaic cell (152, 153, 154) having an oblong shape, the second electrically conductive wire (302, 312, 313, 314) being oriented substantially parallel with the oblong direction of the front side electrode (14) of the second thin-film photovoltaic cell (152, 153, 154) such that the second electrically conductive wire overlaps only with the front side electrode of the second thin-film photovoltaic cell and not with the front side electrode of another thin-film photovoltaic cell;
establishing (405) a first electrical connection between the first device electrode (201, 211, 221, 231) and the front side electrode (14) of the first thin-film photovoltaic cell (151, 152, 153) by means of the first electrically conductive wire (301, 311, 312, 313), over substantially the entire area where the first electrically conductive wire overlays the front side electrode of the first thin-film photovoltaic cell; and
establishing (406) a second electrical connection between the second device electrode (202, 212, 222, 232) and the front side electrode (14) of the second thin-film photovoltaic cell (152, 153, 154) by means of the second electrically conductive wire (302, 312, 313, 314), over substantially the entire area where the second electrically conductive wire overlays the front side electrode of the second thin-film photovoltaic cell.

9. The method (400) for fabricating a thin-film photovoltaic module (10) according to claim 8, further comprising performing (407) an encapsulation process, thereby encapsulating the plurality of thin-film photovoltaic cells (15, 151, 152, 153, 154), wherein the encapsulation process comprises a lamination step.

10. The method (400) for fabricating a thin-film photovoltaic module (10) according to claim 9, wherein positioning (402) the at least one electronic device (20, 21, 22, 23) on the substrate (11) at a lateral edge of the thin-film photovoltaic module (10) comprises positioning the at least one electronic device (20, 21, 22, 23) over the electrically insulating substrate (11), and wherein performing (407) the encapsulation process comprises:
providing a layer of encapsulation material fully covering the front side of the plurality of thin-film photovoltaic cells (15, 151, 152, 153, 154), the at least one electronic device (20, 21, 22, 23), the first electrically conductive wire (301, 311, 312, 313) and the second electrically conductive wire (302, 312, 313, 314);
providing an optically transparent front encapsulation sheet over the layer of encapsulation material; and
performing a lamination step, thereby bonding the optically transparent front encapsulation sheet to the electrically insulating substrate, with the plurality of thin-film photovoltaic cells 15, 151, 152, 153, 154), the at least one electronic device (20, 21, 22, 23), the first electrically conductive wire (301, 311, 312, 313) and the second electrically conductive wire (302, 312, 313, 314) being sandwiched therein between.

11. The method (400) for fabricating a thin-film photovoltaic module (10) according to any of claims 9 or 10, wherein the first electrically conductive wire (301, 311, 312, 313) and the second electrically conductive wire (302, 312, 313, 314) comprise a solderable material and wherein establishing (405) the first electrical connection between the first device electrode (201, 211, 221, 231) and the front side electrode (14) of the first thin-film photovoltaic cell (151, 152, 153) is done simultaneously with the lamination step, and wherein establishing (406) the second electrical connection between the second device electrode (202, 212, 222, 232) and the front side electrode (14) of the second thin-film photovoltaic (152, 153, 154) cell is done simultaneously with the lamination step.

12. The method (400) for fabricating a thin-film photovoltaic module (10) according to any of claims 8 to 11, further comprising forming a plurality of electrically conductive elements (40) above the optically transparent front side electrode (14) of at least part of the plurality of thin-film photovoltaic cells (15, 151, 152, 153, 154) and establishing an electrical contact between the plurality of electrically conductive elements (40) and the underlying front side electrode (14), wherein the front side electrode (14) and the plurality of electrically conductive elements (40) have an oblong shape and wherein the plurality of electrically conductive elements (40) is oriented with their oblong direction at an angle of at least 60 degrees with respect to the oblong direction of the underlying front side electrode (14).

## Patentansprüche

1. Ein Dünnschicht-Photovoltaikmodul (10), umfassend:
eine Vielzahl von Dünnschicht-Photovoltaikzellen (15, 151, 152, 153, 154), wobei jede der Dünnschicht-Photovoltaikzellen eine Zellenlänge und eine Zellenbreite aufweist,
wobei die Vielzahl von Dünnschicht-Photovoltaikzellen (15, 151, 152, 153, 154) auf einem elektrisch isolierenden Substrat (11) gebildet ist, wobei eine Rückseite der Vielzahl von Dünnschicht-Photovoltaikzellen (15, 151, 152, 153, 154) zum elektrisch isolierenden Substrat (11) ausgerichtet ist;
wobei jede der Vielzahl von Dünnschicht-Photovoltaikzellen (15, 151, 152, 153, 154) eine optisch transparente vorderseitige Elektrode (14) an einer der Rückseite gegenüberliegenden Vorderseite aufweist;
wobei die Vielzahl von Dünnschicht-Photovoltaikzellen (15, 151, 152, 153, 154) in einer Richtung entsprechend der Zellenlänge elektrisch in Reihe verbunden ist;
und;
mindestens eine elektronische Vorrichtung (20, 21, 22, 23) eine erste Vorrichtungselektrode (201, 211, 221, 231) und eine zweite Vorrichtungselektrode (202, 212, 222, 232) umfasst,
wobei die mindestens eine elektronische Vorrichtung (20, 21, 22, 23) eine Überbrückungsdiode, einen Schalter, einen DC/DC-Wandler, einen Kondensator, einen Transistor, eine Energiespeichervorrichtung oder eine Last umfasst;
wobei die mindestens eine elektronische Vorrichtung (20, 21, 22, 23) auf dem Substrat (11) an einem seitlichen Rand des Dünnschicht-Photovoltaikmoduls (10) neben der Vielzahl von Dünnschicht-Photovoltaikzellen (15, 151, 152, 153, 154) positioniert ist;
wobei die erste Vorrichtungselektrode (201, 211, 221, 231) elektrisch mit der Vorderseitenelektrode (14) einer ersten Dünnschicht-Photovoltaikzelle (151, 152, 153) mittels eines ersten elektrisch leitfähigen Drahtes (301, 311, 312, 313) verbunden ist, wobei die zweite Vorrichtungselektrode (202, 212, 222, 232) elektrisch mit der Vorderseitenelektrode (14) einer zweiten Dünnschicht-Photovoltaikzelle (152, 153, 154) mittels eines zweiten elektrisch leitfähigen Drahtes (302, 312, 313, 314) verbunden ist, und
wobei der erste elektrisch leitfähige Draht (301, 311, 312, 313) die vorderseitige Elektrode (14) der ersten Dünnschicht-Photovoltaikzelle (151, 152, 153) überlagert und wobei der zweite elektrisch leitfähige Draht (302, 312, 313, 314) die vorderseitige Elektrode (14) der zweiten Dünnschicht-Photovoltaikzelle (152, 153, 154) überlagert.
wobei die optisch transparente vorderseitige Elektrode (14) der Vielzahl von Dünnschicht-Photovoltaikzellen (15, 151, 152, 153, 154) eine längliche Form aufweist und wobei der erste elektrisch leitfähige Draht (301, 311, 312, 313) im Wesentlichen parallel zu der länglichen Richtung der vorderseitigen Elektrode (14) der ersten Dünnschicht-Photovoltaikzelle (151, 152, 153) ausgerichtet ist, so dass der erste elektrisch leitfähige Draht nur mit der vorderseitigen Elektrode der ersten Dünnschicht-Photovoltaikzelle und nicht mit der vorderseitigen Elektrode einer anderen Dünnschicht-Photovoltaikzelle überlappt und der zweite elektrisch leitfähige Draht (302, 312, 313, 314) im Wesentlichen parallel zur länglichen Richtung der vorderseitigen Elektrode (14) der zweiten Dünnschicht-Photovoltaikzelle (152, 153, 154) ausgerichtet ist, so dass der zweite elektrisch leitfähige Draht nur mit der vorderseitigen Elektrode der zweiten Dünnschicht-Photovoltaikzelle und nicht mit der vorderseitigen Elektrode einer anderen Dünnschicht-Photovoltaikzelle überlappt,
und wobei der elektrische Kontakt zwischen dem ersten elektrisch leitfähigen Draht (301, 311, 312, 313) und der vorderseitigen Elektrode (14) der ersten Dünnschicht-Photovoltaikzelle (151, 152, 153) und zwischen dem zweiten elektrisch leitfähigen Draht (302, 312, 313, 314) und der vorderseitigen Elektrode (14) der zweiten Dünnschicht-Photovoltaikzelle (152, 153, 154) im Wesentlichen über den gesamten Bereich hergestellt wird, an dem der elektrisch leitfähige Draht die entsprechende vorderseitige Elektrode überlagert.

2. Das Dünnschicht-Photovoltaikmodul (10) nach Anspruch 1, wobei der erste elektrisch leitfähige Draht (301, 311, 312, 313) einen elektrischen Widerstand aufweist, der im Wesentlichen niedriger ist als ein elektrischer Widerstand der vorderseitigen Elektrode (14) der ersten Dünnschicht-Photovoltaikzelle (151, 152, 153) und wobei der zweite elektrisch leitfähige Draht (302, 312, 313, 314) einen elektrischen Widerstand aufweist, der im Wesentlichen niedriger ist als ein elektrischer Widerstand der vorderseitigen Elektrode (14) der zweiten Dünnschicht-Photovoltaikzelle (152, 153, 154).

3. Das Dünnschicht-Photovoltaikmodul (10) nach Anspruch 1 oder Anspruch 2, wobei die Vielzahl von Dünnschicht-Photovoltaikzellen (15, 151, 152, 153, 154) monolithisch auf dem elektrisch isolierenden Substrat integriert ist.

4. Das Dünnschicht-Photovoltaikmodul (10) nach einem der vorstehenden Ansprüche, wobei das Dünnschicht-Photovoltaikmodul (10) einen ersten elektrischen Kontakt (17) zwischen der vorderseitigen Elektrode (14) der ersten Dünnschicht-Photovoltaikzelle (151, 152, 153) und dem ersten elektrisch leitfähigen Draht (301, 311, 312, 313) umfasst, wobei sich der erste elektrische Kontakt (17) über einen wesentlichen Teil der ersten vorderseitigen Elektrode (14) entlang der Breitenrichtung der ersten Dünnschicht-Photovoltaikzelle (151, 152, 153) erstreckt, und wobei das Dünnschicht-Photovoltaikmodul (10) einen zweiten elektrischen Kontakt (17) zwischen der vorderseitigen Elektrode (14) der zweiten Dünnschicht-Photovoltaikzelle (152, 153, 154) und dem zweiten elektrisch leitfähigen Draht (302, 312, 313, 314) umfasst, wobei sich der zweite elektrische Kontakt (17) über einen wesentlichen Teil der zweiten vorderseitigen Elektrode (14) entlang der Breitenrichtung der zweiten Dünnschicht-Photovoltaikzelle (152, 153, 154) erstreckt.

5. Das Dünnschicht-Photovoltaikmodul (10) nach einem der vorstehenden Ansprüche, weiter umfassend eine Vielzahl von elektrisch leitfähigen Elementen (40) über der optisch transparenten vorderseitigen Elektrode (14) mindestens eines Teils der Vielzahl von Dünnschicht-Photovoltaikzellen (15, 151, 152, 153, 154), wobei die Vielzahl von elektrisch leitfähigen Elementen (40) in elektrischem Kontakt mit der darunter liegenden vorderseitigen Elektrode (14) steht, wobei die vorderseitige Elektrode (14) und die Vielzahl von elektrisch leitfähigen Elementen (40) eine längliche Form aufweisen und wobei die Vielzahl von elektrisch leitfähigen Elementen (40) mit ihrer länglichen Richtung in einem Winkel von mindestens 60 Grad in Bezug auf die längliche Richtung der darunterliegenden vorderseitigen Elektrode (14) ausgerichtet sind.

6. Das Dünnschicht-Photovoltaikmodul (10) nach Anspruch 5, wobei die Vielzahl von elektrisch leitfähigen Elementen (40) mit ihrer länglichen Richtung im Wesentlichen orthogonal zu der länglichen Richtung der darunterliegenden vorderseitigen Elektrode (14) ausgerichtet sind.

7. Das Dünnschicht-Photovoltaikmodul (10) nach einem der vorstehenden Ansprüche, wobei die mindestens eine elektronische Vorrichtung (20, 21, 22, 23) eine Vielzahl von Dünnschicht-Photovoltaikzellen (15) überbrückt, die zwischen der ersten Dünnschicht-Photovoltaikzelle (151, 152, 153) und der zweiten Photovoltaikzelle (152, 153, 154) in Reihe verbunden sind, wobei die Anzahl der überbrückten Dünnschicht-Photovoltaikzellen (15) im Bereich zwischen 5 und 20 liegt.

8. Ein Verfahren (400) zum Herstellen eines Dünnschicht-Photovoltaikmoduls (10), wobei das Verfahren umfasst:
zuerst Bilden (401) einer Vielzahl von in Reihe verbundenen Dünnschicht-Photovoltaikzellen (15, 151, 152, 153, 154) auf einem elektrisch isolierenden Substrat (11), wobei eine Rückseite der Vielzahl von Dünnschicht-Photovoltaikzellen (15, 151, 152, 153, 154) zum Substrat (11) ausgerichtet ist, wobei das Bilden der Vielzahl von in Reihe verbundenen Dünnschicht-Photovoltaikzellen (15, 151, 152, 153, 154) das Bilden einer optisch transparenten vorderseitigen Elektrode (14) an einer Vorderseite jeder der Vielzahl von Dünnschicht-Photovoltaikzellen (15, 151, 152, 153, 154) umfasst;
als Nächstes, Positionieren (402) mindestens einer elektronischen Vorrichtung (20, 21, 22, 23) auf dem Substrat (11) an einem seitlichen Rand des Dünnschicht-Photovoltaikmoduls (10), neben der Vielzahl von Dünnschicht-Photovoltaikzellen (15, 151, 152, 153, 154), wobei die mindestens eine elektronische Vorrichtung (20, 21, 22, 23) eine erste Vorrichtungselektrode (201, 211, 221, 231) und eine zweite Vorrichtungselektrode (202, 212, 222, 232) umfasst und wobei die mindestens eine elektronische Vorrichtung (20, 21, 22, 23) eine Bypass-Diode, einen Schalter, einen DC/DC-Wandler, einen Kondensator, einen Transistor, eine Energiespeichervorrichtung oder eine Last umfasst;
Positionieren (403) eines ersten elektrisch leitfähigen Drahtes (301, 311, 312, 313) über der optisch transparenten vorderseitigen Elektrode (14) einer ersten Dünnschicht-Photovoltaikzelle (151, 152, 153), wobei die optisch transparente vorderseitige Elektrode (14) der ersten Dünnschicht-Photovoltaikzelle (151, 152, 153) eine längliche Form aufweist, wobei der erste elektrisch leitfähige Draht (301, 311, 312, 313) im Wesentlichen parallel zu der länglichen Richtung der vorderseitigen Elektrode (14) der ersten Dünnschicht-Photovoltaikzelle (151, 152, 153) ausgerichtet ist, so dass der erste elektrisch leitfähige Draht nur mit der vorderseitigen Elektrode der ersten Dünnschicht-Photovoltaikzelle und nicht mit der vorderseitigen Elektrode einer anderen Dünnschicht-Photovoltaikzelle überlappt;
Positionieren (404) eines zweiten elektrisch leitfähigen Drahtes (302, 312, 313, 314) über der optisch transparenten vorderseitigen Elektrode (14) einer zweiten Dünnschicht-Photovoltaikzelle (152, 153, 154), wobei die optisch transparente vorderseitige Elektrode (14) der zweiten Dünnschicht-Photovoltaikzelle (152, 153, 154) eine längliche Form aufweist, wobei der zweite elektrisch leitfähige Draht (302, 312, 313, 314) im Wesentlichen parallel zu der länglichen Richtung der vorderseitigen Elektrode (14) der zweiten Dünnschicht-Photovoltaikzelle (152, 153, 154) ausgerichtet ist, so dass der zweite elektrisch leitfähige Draht nur mit der vorderseitigen Elektrode der zweiten Dünnschicht-Photovoltaikzelle und nicht mit der vorderseitigen Elektrode einer anderen Dünnschicht-Photovoltaikzelle überlappt;
Herstellen (405) einer ersten elektrischen Verbindung zwischen der ersten Vorrichtungselektrode (201, 211, 221, 231) und der vorderseitigen Elektrode (14) der ersten Dünnschicht-Photovoltaikzelle (151, 152, 153) mittels des ersten elektrisch leitfähigen Drahtes (301, 311, 312, 313) über im Wesentlichen den gesamten Bereich, an dem der erste elektrisch leitfähige Draht die vorderseitige Elektrode der ersten Dünnfilm-Photovoltaikzelle überlagert; und
Herstellen (406) einer zweiten elektrischen Verbindung zwischen der zweiten Vorrichtungselektrode (202, 212, 222, 232) und der vorderseitigen Elektrode (14) der zweiten Dünnschicht-Photovoltaikzelle (152, 153, 154) mittels des zweiten elektrisch leitfähigen Drahtes (302, 312, 313, 314), über im Wesentlichen den gesamten Bereich, an dem der zweite elektrisch leitfähige Draht die vorderseitige Elektrode der zweiten Dünnfilm-Photovoltaikzelle überlagert.

9. Das Verfahren (400) zum Herstellen eines Dünnschicht-Photovoltaikmoduls (10) nach Anspruch 8, weiter umfassend das Durchführen (407) eines Einkapselungsprozesses, wodurch die Vielzahl von Dünnschicht-Photovoltaikzellen (15, 151, 152, 153, 154) eingekapselt wird, wobei der Einkapselungsprozess einen Laminierungsschritt umfasst.

10. Das Verfahren (400) zur Herstellung eines Dünnschicht-Photovoltaikmoduls (10) nach Anspruch 9, wobei das Positionieren (402) der mindestens einen elektronischen Vorrichtung (20, 21, 22, 23) auf dem Substrat (11) an einem seitlichen Rand des Dünnschicht-Photovoltaikmoduls (10) das Positionieren der mindestens einen elektronischen Vorrichtung (20, 21, 22, 23) über dem elektrisch isolierenden Substrat (11) umfasst, und wobei das Durchführen (407) des Einkapselungsprozesses umfasst:
Bereitstellen einer Schicht von Einkapselungsmaterial, die die Vorderseite der Vielzahl von Dünnschicht-Photovoltaikzellen (15, 151, 152, 153, 154), die mindestens eine elektronische Vorrichtung (20, 21, 22, 23), den ersten elektrisch leitfähigen Draht (301, 311, 312, 313) und den zweiten elektrisch leitfähigen Draht (302, 312, 313, 314) vollständig abdeckt;
Bereitstellen einer optisch transparenten vorderen Einkapselungsfolie über der Schicht von Einkapselungsmaterial; und
Durchführen eines Laminierungsschrittes, wodurch die optisch transparente vordere Einkapselungsfolie an das elektrisch isolierende Substrat gebondet wird, wobei die Vielzahl von Dünnschicht-Photovoltaikzellen (15, 151, 152, 153, 154), die mindestens eine elektronische Vorrichtung (20, 21, 22, 23), der erste elektrisch leitfähige Draht (301, 311, 312, 313) und der zweite elektrisch leitfähige Draht (302, 312, 313, 314) dazwischen angeordnet sind.

11. Das Verfahren (400) zum Herstellen eines Dünnschicht-Photovoltaikmoduls (10) nach einem der Ansprüche 9 oder 10, wobei der erste elektrisch leitfähige Draht (301, 311, 312, 313) und der zweite elektrisch leitfähige Draht (302, 312, 313, 314) ein lötbares Material umfassen und wobei das Herstellen (405) der ersten elektrischen Verbindung zwischen der ersten Vorrichtungselektrode (201, 211, 221, 231) und der vorderseitigen Elektrode (14) der ersten Dünnschicht-Photovoltaikzelle (151, 152, 153) gleichzeitig mit dem Laminierungsschritt erfolgt und wobei das Herstellen (406) der zweiten elektrischen Verbindung zwischen der zweiten Vorrichtungselektrode (202, 212, 222, 232) und der vorderseitigen Elektrode (14) der zweiten Dünnschicht-Photovoltaikzelle (152, 153, 154) gleichzeitig mit dem Laminierungsschritt durchgeführt wird.

12. Das Verfahren (400) zum Herstellen eines Dünnschicht-Photovoltaikmoduls (10) nach einem der Ansprüche 8 bis 11, weiter umfassend das Bilden einer Vielzahl von elektrisch leitfähigen Elementen (40) über der optisch transparenten vorderseitigen Elektrode (14) mindestens eines Teils der Vielzahl von Dünnschicht-Photovoltaikzellen (15, 151, 152, 153, 154) und Herstellen eines elektrischen Kontakts zwischen der Vielzahl von elektrisch leitfähigen Elementen (40) und der darunterliegenden vorderseitigen Elektrode (14), wobei die vorderseitige Elektrode (14) und die Vielzahl von elektrisch leitfähigen Elementen (40) eine längliche Form aufweisen und wobei die Vielzahl von elektrisch leitfähigen Elementen (40) mit ihrer länglichen Richtung in einem Winkel von mindestens 60 Grad in Bezug auf die längliche Richtung der darunterliegenden vorderseitigen Elektrode (14) ausgerichtet ist.

## Revendications

1. Un module photovoltaïque à film mince (10) comprenant
une pluralité de cellules photovoltaïques à film mince (15, 151, 152, 153, 154), chacune des cellules photovoltaïques à film mince ayant une longueur de cellule et une largeur de cellule, la pluralité de cellules photovoltaïques à film mince (15, 151, 152, 153, 154) étant formée sur un substrat électriquement isolant (11) avec un côté arrière de la pluralité de cellules photovoltaïques à film mince (15, 151, 152, 153, 154) orienté vers le substrat électriquement isolant (11) ;
où chacune des pluralité de cellules photovoltaïques à film mince (15, 151, 152, 153, 154) a une électrode de côté avant optiquement transparente (14) sur un côté avant opposé au côté arrière ;
où la pluralité de cellules photovoltaïques à film mince (15, 151, 152, 153, 154) est connectée électriquement en série dans une direction correspondant à la longueur de cellule ;
et ;
au moins un dispositif électronique (20, 21, 22, 23) comprenant une première électrode de dispositif (201, 211, 221, 231) et une seconde électrode de dispositif (202, 212, 222, 232), où le ou les dispositifs électroniques (20, 21, 22, 23) comprennent une diode de court-circuit, un commutateur, un convertisseur DC/DC, un condensateur, un transistor, un dispositif de stockage d'énergie ou une charge ;
où le ou les dispositifs électroniques (20, 21, 22, 23) sont positionnés sur le substrat (11) sur un bord latéral du module photovoltaïque à film mince (10), à côté de la pluralité de cellules photovoltaïques à film mince (15, 151, 152, 153, 154) ;
où la première électrode de dispositif (201, 211, 221, 231) est connectée électriquement à l'électrode de côté avant (14) d'une première cellule photovoltaïque à film mince (151, 152, 153) au moyen d'un premier fil électroconducteur (301, 311, 312, 313),
où la seconde électrode de dispositif (202, 212, 222, 232) est connectée électriquement à l'électrode de côté avant (14) d'une seconde cellule photovoltaïque à film mince (152, 153, 154) au moyen d'un second fil électroconducteur (302, 312, 313, 314), et
où le premier fil électroconducteur (301, 311, 312, 313) recouvre l'électrode de côté avant (14) de la première cellule photovoltaïque à film mince (151, 152, 153) et où le second fil électroconducteur (302, 312, 313, 314) recouvre l'électrode de côté avant (14) de la seconde cellule photovoltaïque à film mince (152, 153, 154) ;
où l'électrode de côté avant optiquement transparente (14) de la pluralité de cellules photovoltaïques à film mince (15, 151, 152, 153, 154) a une forme allongée, et où le premier fil électroconducteur (301, 311, 312, 313) est orienté sensiblement parallèlement à la direction allongée de l'électrode de côté avant (14) de la première cellule photovoltaïque à film mince (151, 152, 153) de telle sorte que le premier fil électroconducteur recouvre seulement l'électrode de côté avant de la première cellule photovoltaïque à film mince et pas l'électrode de côté avant d'une autre cellule photovoltaïque à film mince et que le second fil électroconducteur (302, 312, 313, 314) est orienté sensiblement parallèlement à la direction allongée de l'électrode de côté avant (14) de la seconde cellule photovoltaïque à film mince (152, 153, 154) de telle sorte que le second fil électroconducteur recouvre seulement l'électrode de côté avant de la seconde cellule photovoltaïque à film mince et pas l'électrode de côté avant d'une autre cellule photovoltaïque à film mince, et où le contact électrique entre le premier fil électroconducteur (301, 311, 312, 313) et l'électrode de côté avant (14) de la première cellule photovoltaïque à film mince (151, 152, 153) et entre le second fil électroconducteur (302, 312, 313, 314) et l'électrode de côté avant (14) de la seconde cellule photovoltaïque à film mince (152, 153, 154) est établi sur sensiblement la totalité de la zone où le fil électroconducteur recouvre l'électrode de côté avant correspondante.

2. Le module photovoltaïque à film mince (10) selon la revendication 1, où le premier fil électroconducteur (301, 311, 312, 313) a une résistance électrique qui est sensiblement inférieure à une résistance électrique de l'électrode de côté avant (14) de la première cellule photovoltaïque à film mince (151, 152, 153) et où le second fil électroconducteur (302, 312, 313, 314) a une résistance électrique qui est sensiblement inférieure à une résistance électrique de l'électrode de côté avant (14) de la seconde cellule photovoltaïque à film mince (152, 153, 154).

3. Le module photovoltaïque à film mince (10) selon la revendication 1 ou la revendication 2, où la pluralité de cellules photovoltaïques à film mince (15, 151, 152, 153, 154) est intégrée monolithiquement sur le substrat électriquement isolant.

4. Le module photovoltaïque à film mince (10) selon l'une quelconque des revendications précédentes, où le module photovoltaïque à film mince (10) comprend un premier contact électrique (17) entre l'électrode de côté avant (14) de la première cellule photovoltaïque à film mince (151, 152, 153) et le premier fil électroconducteur (301, 311, 312, 313), où le premier contact électrique (17) s'étend sur une partie substantielle de la première électrode de côté avant (14) le long de la direction de largeur de la première cellule photovoltaïque à film mince (151, 152, 153), et où le module photovoltaïque à film mince (10) comprend un second contact électrique (17) entre l'électrode de côté avant (14) de la seconde cellule photovoltaïque à film mince (152, 153, 154) et le second fil électroconducteur (302, 312, 313, 314), où le second contact électrique (17) s'étend sur une partie substantielle de la seconde électrode de côté avant (14) le long de la direction de largeur de la seconde cellule photovoltaïque à film mince (152, 153, 154).

5. Le module photovoltaïque à film mince (10) selon l'une quelconque des revendications précédentes, comprenant en outre une pluralité d'éléments électroconducteurs (40) au-dessus de l'électrode de côté avant optiquement transparente (14) d'au moins une partie de la pluralité de cellules photovoltaïques à film mince (15, 151, 152, 153, 154), où la pluralité d'éléments électroconducteurs (40) est en contact électrique avec l'électrode de côté avant sous-jacente (14), où l'électrode de côté avant (14) et la pluralité d'éléments électroconducteurs (40) ont une forme allongée et où la pluralité d'éléments électroconducteurs (40) est orientée avec leur direction allongée à un angle d'au moins 60 degrés par rapport à la direction allongée de l'électrode de côté avant sous-jacente (14).

6. Le module photovoltaïque à film mince (10) selon la revendication 5, où la pluralité d'éléments électroconducteurs (40) est orientée avec leur direction allongée sensiblement orthogonale à la direction allongée de l'électrode de côté avant sous-jacente (14).

7. Le module photovoltaïque à couche mince (10) selon l'une quelconque des précédentes revendications, où le au moins un dispositif électronique(20, 21, 22, 23) fait le pont entre une pluralité de cellules photovoltaïques à couche mince (15) connectées en série entre la première cellule photovoltaïque à couche mince (151, 152, 153) et la seconde cellule photovoltaïque (152, 153, 154), le nombre de cellules photovoltaïques à couche mince (15) pontées étant dans la plage entre 5 et 20.

8. Un procédé (400) pour fabriquer un module photovoltaïque à couche mince (10), le procédé comprenant :
d'abord former (401) une pluralité de cellules photovoltaïques à couche mince (15, 151, 152, 153, 154) connectées en série sur un substrat électriquement isolant (11) avec un côté arrière de la pluralité de cellules photovoltaïques à couche mince (15, 151, 152, 153, 154) orienté vers le substrat (11), où former la pluralité de cellules photovoltaïques à couche mince (15, 151, 152, 153, 154) comprend former une électrode de côté avant optiquement transparente (14) sur un côté avant de chacune des cellules photovoltaïques à couche mince (15, 151, 152, 153, 154) ; ensuite, positionner (402) au moins un dispositif électronique (20, 21, 22, 23) sur le substrat (11) à un bord latéral du module photovoltaïque à couche mince (10), à côté de la pluralité de cellules photovoltaïques à couche mince (15, 151, 152, 153, 154), où le ou les dispositifs électroniques (20, 21, 22, 23) comprennent une première électrode de dispositif (201, 211, 221, 231) et une seconde électrode de dispositif (202, 212, 222, 232) et où le ou les dispositifs électroniques (20, 21, 22, 23) comprennent une diode de contournement, un interrupteur, un convertisseur DC/DC, un condensateur, un transistor, un dispositif de stockage d'énergie ou une charge ; positionner (403) un premier fil électriquement conducteur (301, 311, 312, 313) au-dessus de l'électrode de côté avant optiquement transparente (14) d'une première cellule photovoltaïque à couche mince (151, 152, 153), l'électrode de côté avant optiquement transparente (14) de la première cellule photovoltaïque à couche mince (151, 152, 153) ayant une forme oblongue, le premier fil électriquement conducteur (301, 311, 312, 313) étant orienté sensiblement parallèlement à la direction oblongue de l'électrode de côté avant (14) de la première cellule photovoltaïque à couche mince (151, 152, 153) de telle sorte que le premier fil électriquement conducteur ne chevauche que l'électrode de côté avant de la première cellule photovoltaïque à couche mince et pas celle d'une autre cellule photovoltaïque à couche mince ;
positionner (404) un second fil électriquement conducteur (302, 312, 313, 314) au-dessus de l'électrode de côté avant optiquement transparente (14) d'une seconde cellule photovoltaïque à couche mince (152, 153, 154), l'électrode de côté avant optiquement transparente (14) de la seconde cellule photovoltaïque à couche mince (152, 153, 154) ayant une forme oblongue, le second fil électriquement conducteur (302, 312, 313, 314) étant orienté sensiblement parallèlement à la direction oblongue de l'électrode de côté avant (14) de la seconde cellule photovoltaïque à couche mince (152, 153, 154) de telle sorte que le second fil électriquement conducteur ne chevauche que l'électrode de côté avant de la seconde cellule photovoltaïque à couche mince et pas celle d'une autre cellule photovoltaïque à couche mince ;
établir (405) une première connexion électrique entre la première électrode de dispositif (201, 211, 221, 231) et l'électrode de côté avant (14) de la première cellule photovoltaïque à couche mince (151, 152, 153) au moyen du premier fil électriquement conducteur (301, 311, 312, 313), sur sensiblement toute la surface où le premier fil électriquement conducteur recouvre l'électrode de côté avant de la première cellule photovoltaïque à couche mince ; et
établir (406) une seconde connexion électrique entre la seconde électrode de dispositif (202, 212, 222, 232) et l'électrode de côté avant (14) de la seconde cellule photovoltaïque à couche mince (152, 153, 154) au moyen du second fil électriquement conducteur (302, 312, 313, 314), sur sensiblement toute la surface où le second fil électriquement conducteur recouvre l'électrode de côté avant de la seconde cellule photovoltaïque à couche mince.

9. Le procédé (400) pour fabriquer un module photovoltaïque à couche mince (10) selon la revendication 8 comprenant en outre (407) la réalisation d'un processus d'encapsulation, encapsulant ainsi la pluralité de cellules photovoltaïques à couche mince (15, 151, 152, 153, 154), où le processus d'encapsulation comprend une étape de lamination.

10. Le procédé (400) pour fabriquer un module photovoltaïque à couche mince (10) selon la revendication 9, où positionner (402) l'au moins un dispositif électronique (20, 21, 22, 23) sur le substrat (11) à un bord latéral du module photovoltaïque à couche mince (10) comprend positionner l'au moins un dispositifs électronique (20, 21, 22, 23) sur le substrat électriquement isolant (11), et où effectuer (407) le processus d'encapsulation comprend :
fournir une couche de matériau d'encapsulation recouvrant entièrement le côté avant de la pluralité de cellules photovoltaïques à couche mince (15, 151, 152, 153, 154), l'au moins un dispositif électronique (20, 21, 22, 23), le premier fil électriquement conducteur (301, 311, 312, 313) et le second fil électriquement conducteur (302, 312, 313, 314) ;
fournir une feuille d'encapsulation avant optiquement transparente sur la couche de matériau d'encapsulation ; et
effectuer une étape de lamination, ce qui permet de lier la feuille d'encapsulation avant optiquement transparente au substrat électriquement isolant, avec la pluralité de cellules photovoltaïques à couche mince (15, 151, 152, 153, 154), l'au moins un dispositif électronique (20, 21, 22, 23), le premier fil électriquement conducteur (301, 311, 312, 313) et le second fil électriquement conducteur (302, 312, 313, 314) étant pris en sandwich entre les deux.

11. Le procédé (400) pour fabriquer un module photovoltaïque à couche mince (10) selon l'une quelconque des revendications 9 ou 10,
où le premier fil électriquement conducteur (301, 311, 312, 313) et le second fil électriquement conducteur (302, 312, 313, 314) comprennent un matériau soudable et où établir (405) la première connexion électrique entre la première électrode de dispositif (201, 211, 221, 231) et l'électrode de côté avant (14) de la première cellule photovoltaïque à couche mince (151, 152, 153) est effectuée simultanément avec l'étape de lamination, et où établir (406) la seconde connexion électrique entre la seconde électrode de dispositif (202, 212, 222, 232) et l'électrode de côté avant (14) de la seconde cellule photovoltaïque à couche mince (152, 153, 154) est effectué simultanément avec l'étape de lamination.

12. Le procédé (400) pour fabriquer un module photovoltaïque à couche mince (10) selon l'une quelconque des revendications 8 à 11 comprenant en outre former une pluralité d'éléments électriquement conducteurs (40) au-dessus de l'électrode de côté avant optiquement transparente (14) d'au moins une partie de la pluralité de cellules photovoltaïques à couche mince (15, 151, 152, 153, 154) et établir un contact électrique entre la pluralité d'éléments électriquement conducteurs (40) et l'électrode de côté avant (14) sous-jacente, où l'électrode de côté avant (14) et la pluralité d'éléments électriquement conducteurs (40) ont une forme oblongue et où la pluralité d'éléments électriquement conducteurs (40) est orientée avec leur direction oblongue à un angle d'au moins 60 degrés par rapport à la direction oblongue de l'électrode de côté avant (14) sous-jacente.
